# EUROPEAN PATENT APPLICATION

(11) **EP 2 420 723 A1**
(43) Date of publication of application: **22.02.2012**
(21) Application number: 10764204.3
(22) Date of filing: 17.03.2010
(51) Int. Cl.: F21S 2/00, F21V 5/04, G02F 1/13357, F21Y 101/02

(54) **PLANAR LIGHT SOURCE DEVICE AND DISPLAY DEVICE PROVIDED WITH THE PLANAR LIGHT SOURCE DEVICE**

(30) Priority: 14.04.2009 JP 2009098397
(71) Applicant: Sharp Kabushiki Kaisha, Osaka-shi, Osaka 545-8522 (JP)
(72) Inventor: OGATA, Nobuo, Osaka-shi, Osaka 545-8522 (JP); ITOH, Shin, Osaka-shi, Osaka 545-8522 (JP)
(74) Representative: Müller - Hoffmann & Partner
(86) International application number: PCT/JP2010/001910
(87) International publication number: WO 2010/119617

(57) **Abstract**

A planar light source device is provided which satisfies the inequality α1<α2, where α1 is the angle formed between the direction in which an array of mortar-shaped light-emitting devices (50) emits light of maximum intensity and a vertical direction on a plane containing the vertical direction and the X direction or on a plane containing the vertical direction and the Y direction and α2 is the angle formed between the direction in which the array of mortar-shaped light-emitting devices (50) emits light of maximum intensity and a diagonal direction (C) across the array on a plane containing the vertical direction and the diagonal direction (C), the first and second unevenness eliminating sheets (113a and 113b) each having surfaces one of which is more distant from the light sources than the other and is shaped such that shapes having upwardly convex cross-sections and extending along a longitudinal direction are arranged at pitches (P'), the pitches (Px and Py) being longer than the pitches (P').

## Description

### Technical Field

The present invention relates to a light-emitting device including a sealing body that directs emitted light in a predetermined direction, a planar light source device including an array of such light-emitting devices, and a display device including such a planar light source device.

### Background Art

There has been a liquid crystal display device including, as a backlight that illuminates the back surface of the liquid crystal display panel, a planar light source including an array of light sources such as LEDs (light-emitting diodes). Unlike an edge-light backlight with use of a light guide plate, such a backlight that illuminates the back surface of a liquid crystal display panel without use of a light guide plate is called a direct backlight.

A challenge to light sources for use in a direct backlight has been a reduction in the number of light sources for the purpose of cost reduction, and there has been a need for a special way of expanding light-distribution characteristics. There have been reports on some examples of special ways of expanding light-distribution characteristics, although not disclosed for use as backlight light sources for liquid crystal display panels.

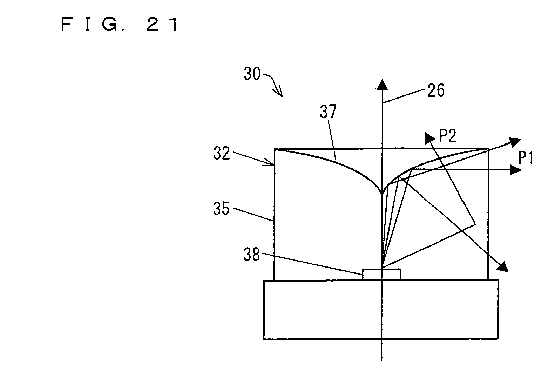

Patent Literature 1 discloses, as a conventional technology, an example of an LED package 30 including an LED chip 38, a lens 32 having a vertical side wall 35, and an funnel-shaped upper surface 37 (Fig. 21).

The LED package 30 has two main light paths through which light travels within the LED package 30. Light that travels through the first light path P1 is light emitted desirably from the LED chip 38, and reaches the upper surface 37, which effects total internal reflection (TIR) that causes the light to exit through the side wall 35 at an angle of approximately 90 degrees with respect to the vertical axis. Light that travels through the second light path P2 is (i) light that is emitted from the LED chip 38 toward the side wall 35 at such an angle that total internal reflection occurs or (ii) light reflected by the side wall 35 to exit the LED package 30 at an angle far from being perpendicular to the vertical axis. The light that travels through the second light path P2 is not preferable, because it places a limit on the efficiency of extraction of light through the side wall 35.

In the example of the LED package 30, it is an object to efficiently take out light through the side wall 35. Such an object does not necessarily correspond to the after-mentioned object of the present application. Further, Patent Literature 1 fails to give a detailed description of the "lens 32 having a vertical side wall 35" or the "funnel-shaped upper surface 37".

Patent Literature 2, which uses an LED in a similar manner to Patent Literature 1, discloses a LED mounted on a surface to have wide directivity. Further, Patent Literature 3 discloses a light source, a light guide, and a planar light-emitting device that can be used in a railway signal light, a traffic signal light, a large-sized display, a vehicle's tail light, etc.

Further, Patent Literatures 4 and 5 each discloses a direct backlight configured to include an optical sheet by which light from an arrangement of light sources or from a light source is uniformed in a plane.

### Citation List

### Patent Literature 1

Japanese Patent Application Publication, Tokukai, No. 2003-008081 A (Publication Date: January 10, 2003)

### Patent Literature 2

Japanese Patent Application Publication, Tokukai, No. 2002-344027 A (Publication Date: November 29, 2002)

### Patent Literature 3

Japanese Patent No. 3715635 (patented on September 2, 2005)

### Patent Literature 4

Japanese Patent Application Publication, Tokukai, No. 2008-66086 A (Publication Date: March 21, 2008)

### Patent Literature 5

Japanese Patent Application Publication, Tokukai, No. 2006-324256 A (Publication Date: November 30, 2006)

### Summary of Invention

### Technical Problem

Although these prior literatures each describes a sealing resin lens configured to have wide directivity, they fail to describe what light-distribution characteristics a light-emitting device should have to serve as a light source for a backlight device that is disposed to face the back surface of the display panel of a liquid crystal display device or, in particular, what light-emitting pattern should be formed on a view plane parallel to the substrate of a light-emitting device.

Patent Literature 5 discloses light sources each obtained by covering an LED with a concave lens so that light is emitted from the LED in a direction at an angle to a direction vertical to a surface on which the LED has been placed, and discloses uniformizing in-plane luminance by allowing the light to travel in an oblique direction to enter an optical sheet disposed to face the light sources.

However, Patent Literature 5 fails to describe how a distribution of luminance among the two-dimensional array of light sources along a diagonal direction is uniformized or how the optical sheet should be positioned in relation to the light sources from the perspective of the optical characteristics of the optical sheet for the purpose of reducing the thickness of the backlight device while improving in-plane luminance/color unevenness.

The inventors conducted a detailed study to find that a thin planer light source device with reduced illuminance unevenness and chromaticity unevenness can be achieved by rendering the illumination profile substantially rectangular on a view plane parallel to the substrate of a light-emitting device. Further, this configuration makes it very easy to combine separate light-emitting devices in assembling a planer light source, and if such light-emitting devices are possible, it becomes much easier to control an area active (local dimming) liquid crystal display device.

However, it has been generally believed to be very difficult to stably obtain a light-emitting device having such a special illumination profile, i.e., a light-emitting device having a rectangular illumination profile.

The present invention has been made in view of the foregoing problems, and it is an object of the present invention to provide a thin display device that has little illuminance unevenness or chromaticity unevenness and a planar light source device structured to be suitable for such a display device.

### Solution to Problem

In order to solve the foregoing problems, a planar light source device of the present invention is a planar light source device including: a plurality of light sources arrayed at first intervals along a first direction on a mounting substrate and arrayed at second intervals along a second direction orthogonal to the first direction; and a plurality of optical sheets placed in parallel with the mounting substrate at a distance from the mounting substrate, the light sources each emitting light of maximum intensity in a direction inclined at an oblique angle with respect to a direction vertical to a plane on which the light sources are placed, on a plane containing the vertical direction and the direction along which the light sources are arrayed, the direction in which the light sources each emit light of maximum intensity forming an angle α1 with the vertical direction, on a plane containing the vertical direction and a diagonal direction across the array of light sources, the direction in which the light sources each emit light of maximum intensity forming an angle α2 with the diagonal direction, α1 being less than α2, the optical sheets each having surfaces one of which is more distant from the light sources than the other and is shaped such that shapes having upwardly convex cross-sections and extending along a longitudinal direction are arranged at third intervals, the first intervals and the second intervals being longer than the third intervals.

According to the present invention, the following relationship between the angle α1 and the angle α2 holds: α1<α2. Therefore, when the planar light source device is looked squarely at, light of a predetermined luminance comes also to a position directly above the vicinity of an area between light sources adjacent to each other along the diagonal direction. This makes it possible to reduce luminance unevenness along the diagonal direction.

Further, the first intervals and the second intervals are longer than the third intervals. Therefore, the density of the bright and dart areas can be made higher on a light-emitting pattern as viewed from above the optical sheets, so that luminance unevenness becomes less conspicuous. This makes it possible to provide a planar light source device structured to be suitable for a thin display device that has little illuminance unevenness or chromaticity unevenness.

### Advantageous Effects of Invention

As described above, the planar light source device of the present invention is configured such that: the light sources each emit light of maximum intensity in a direction inclined at an oblique angle with respect to a direction vertical to a plane on which the light sources are placed; on a plane containing the vertical direction and the direction along which the light sources are arrayed, the direction in which the light sources each emit light of maximum intensity forms an angle α1 with the vertical direction; on a plane containing the vertical direction and a diagonal direction across the array of light sources, the direction in which the light sources each emit light of maximum intensity forms an angle α2 with the diagonal direction; α1 being less than α2; the optical sheets each have surfaces one of which is more distant from the light sources than the other and is shaped such that shapes having upwardly convex cross-sections and extending along a longitudinal direction are arranged at third intervals; and the first intervals and the second intervals are longer than the third intervals.

This brings about an effect of providing a planar light source device structured to be suitable for a thin display device that has little illuminance unevenness or chromaticity unevenness.

### Brief Description of Drawings

Fig. 1

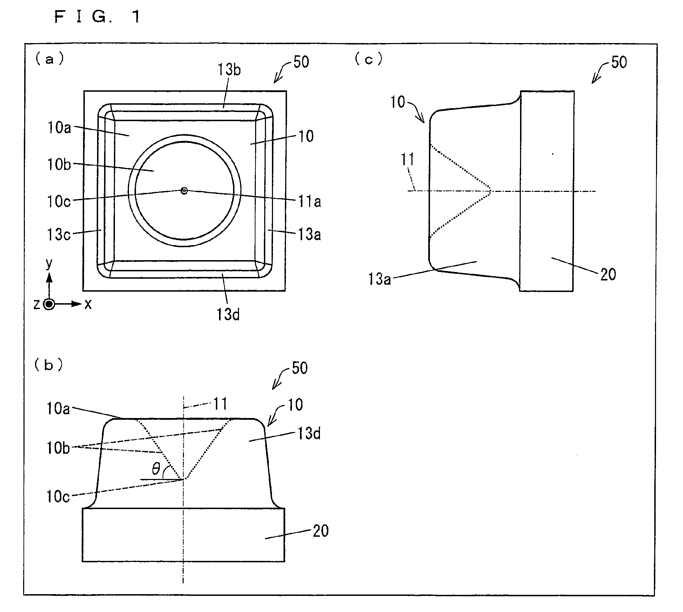

   Fig. 1 shows explanatory diagrams (a) to (c) explaining a mortar-shaped light-emitting device according to an embodiment of the present invention, (a) being a plan view of the mortar-shaped light-emitting device according to the embodiment of the present invention, (b) being a front view of the mortar-shaped light-emitting device according to the embodiment of the present invention, and (c) being a side view of the mortar-shaped light-emitting device according to the embodiment of the present invention.
Fig. 2

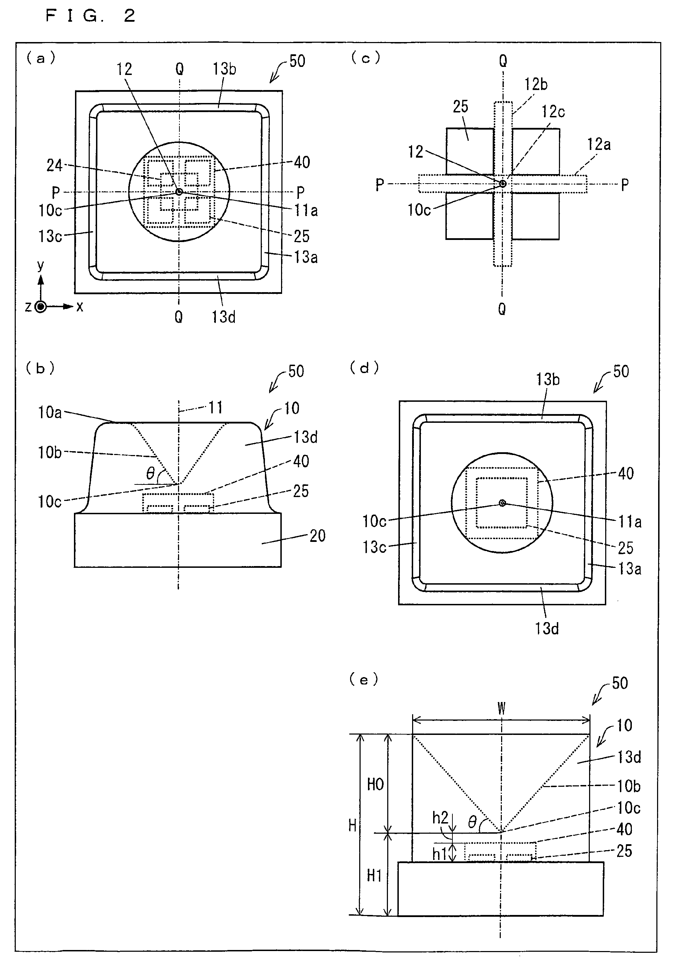

   Fig. 2 shows explanatory diagrams (a) to (e) explaining a mortar-shaped light-emitting device according to an embodiment of the present invention, (a) being a plan view showing an internal structure of the mortar-shaped light-emitting device according to the embodiment of the present invention, (b) being a front view showing the internal structure of the mortar-shaped light-emitting device according to the embodiment of the present invention, (c) being a plan view showing a central space area and a vertex in the mortar-shaped light-emitting device according to the embodiment of the present invention, (d) being a plan view showing one LED chip being die-bonded to a position of intersection between the substrate and the main axis in the mortar-shaped light-emitting device according to the embodiment of the present invention, (e) being a front view showing a preferred height of a sealing lens in the mortar-shaped light-emitting device according to the embodiment of the present invention.
Fig. 3

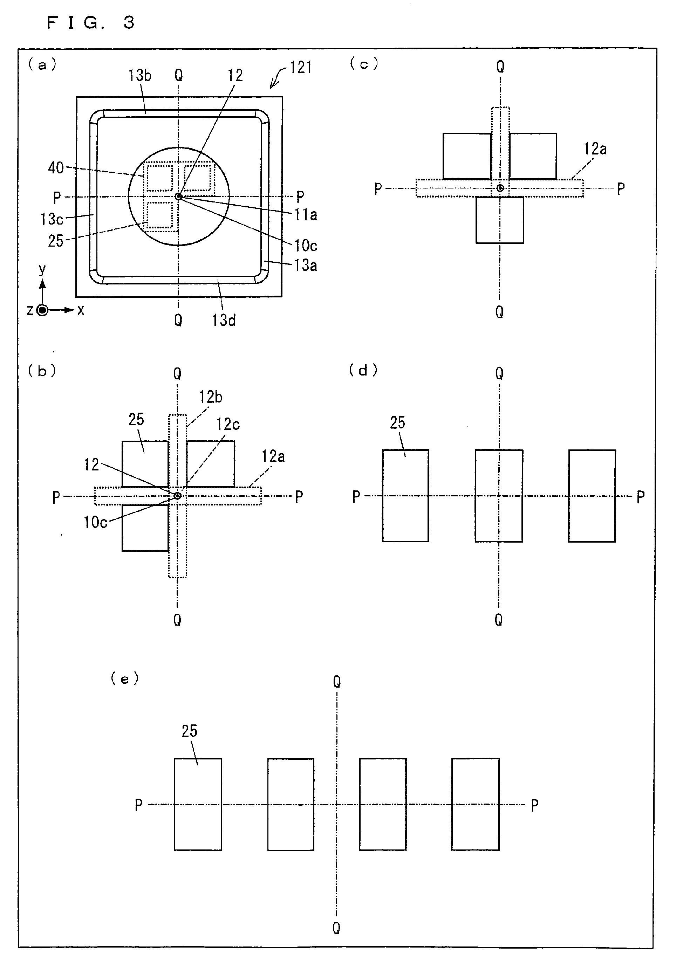

   Fig. 3 shows explanatory diagrams (a) to (c) explaining a mortar-shaped light-emitting device according to an embodiment of the present invention, (a) being a plan view showing an internal structure of the mortar-shaped light-emitting device according to the embodiment of the present invention, (b) and (c) each being an enlarged view of LED chips and an area therearound in the mortar-shaped light-emitting device according to the embodiment of the present invention.
Fig. 4

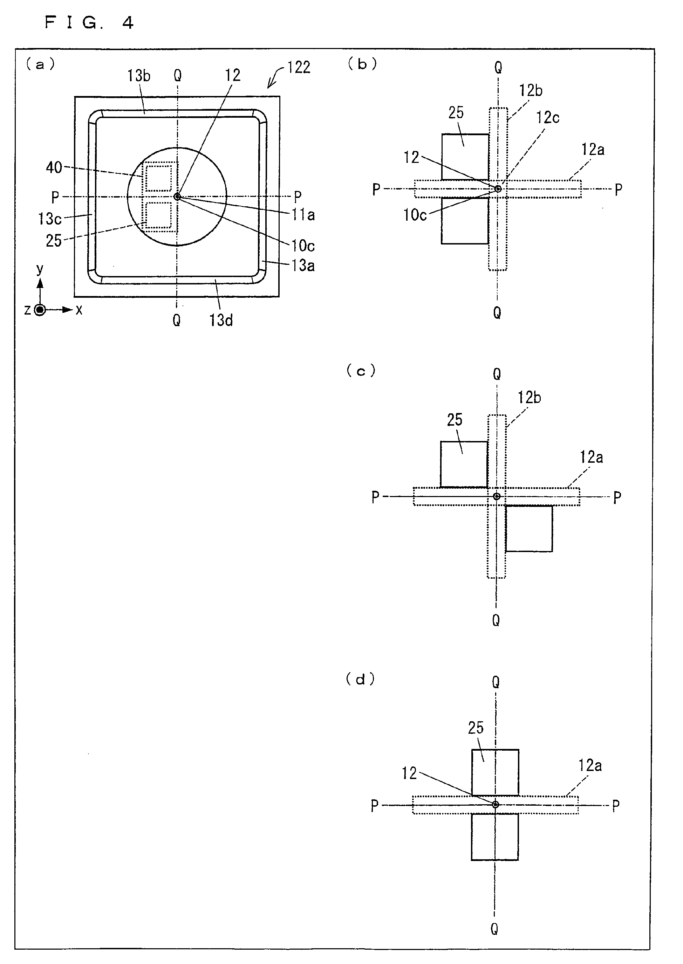

   Fig. 4 shows explanatory diagrams (a) to (d) explaining a mortar-shaped light-emitting device according to an embodiment of the present invention, (a) being a plan view showing an internal structure of a modification of arrangement of LED chips in the mortar-shaped light-emitting device according to the embodiment of the present invention, (b) to (d) each being an enlarged view of LED chips and an area therearound in the mortar-shaped light-emitting device according to the embodiment of the present invention.
Fig. 5

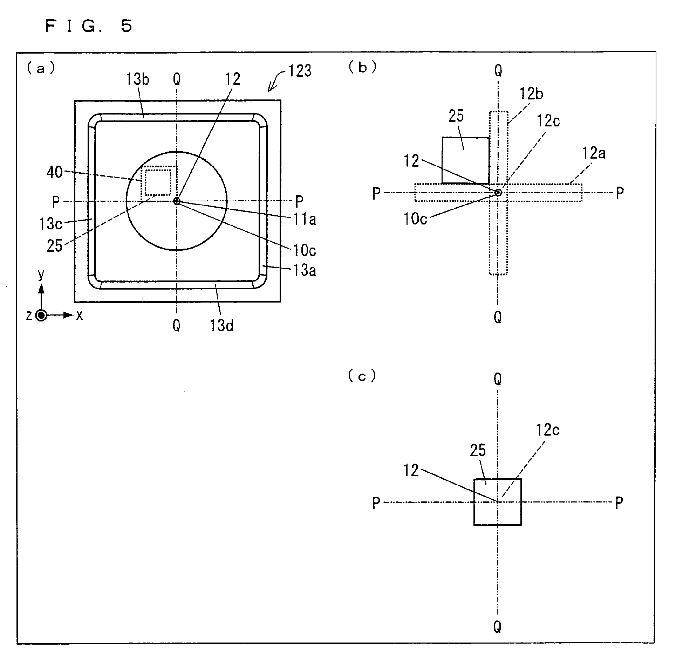

   Fig. 5 shows explanatory diagrams (a) to (c) explaining a mortar-shaped light-emitting device according to an embodiment of the present invention, (a) being a plan view showing an internal structure of the mortar-shaped light-emitting device according to the embodiment of the present invention, (b) and (c) each being an enlarged view of an LED chip and an area therearound in the mortar-shaped light-emitting device according to the embodiment of the present invention.
Fig. 6

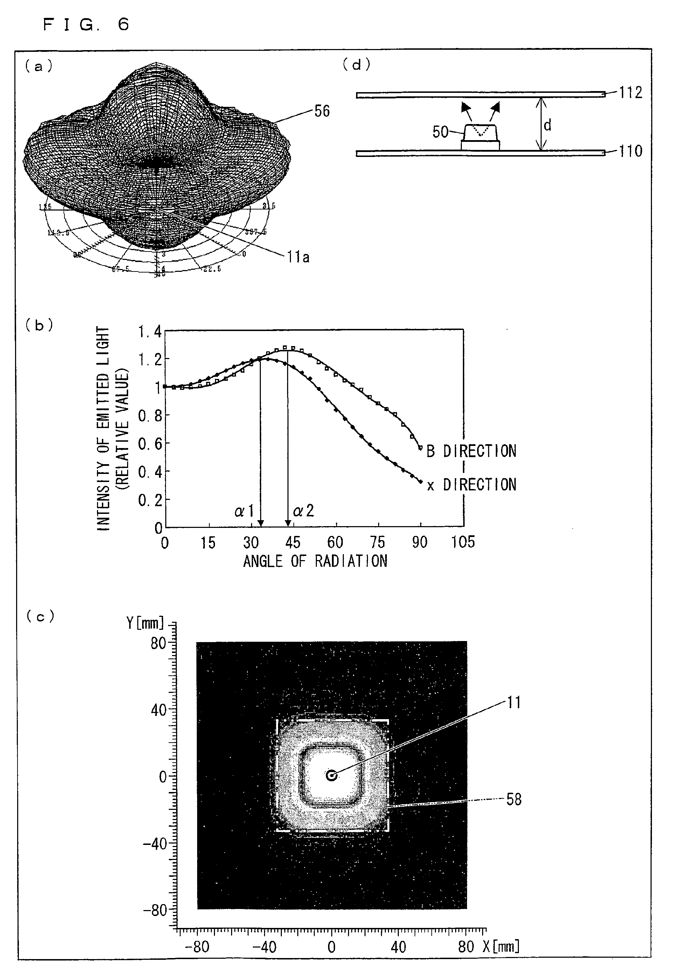

   Fig. 6 shows the light-distribution characteristics (dependence on the angle of radiation of an intensity distribution of emitted light) of a mortar-shaped light-emitting device according to an embodiment of the present invention, the illumination profile (intensity distribution of emitted light on a virtual view plane) of the mortar-shaped light-emitting device according to the embodiment of the present invention, and a method for evaluating the illumination profile of the mortar-shaped light-emitting device according to the embodiment of the present invention, (a) being a simulation diagram three-dimensionally showing the light-distribution characteristics of the mortar-shaped light-emitting device according to the embodiment of the present invention, (b) being a graph showing actual measurements of the light-distribution characteristics (dependence on the angle of radiation of an intensity distribution of emitted light) of a cross-section containing the vertical direction and the x direction and a cross-section containing the vertical direction and the B direction (obtained by rotating the x direction 45 degrees in the x-y plane), the cross-sections being cut out of the diagram showing the light-distribution characteristics of the mortar-shaped light-emitting device according to the embodiment of the present invention, (c) being a simulation diagram showing the illumination profile of the mortar-shaped light-emitting device according to the embodiment of the present invention, (d) showing the method for evaluating the illumination profile of the mortar-shaped light-emitting device according to the embodiment of the present invention.
Fig. 7

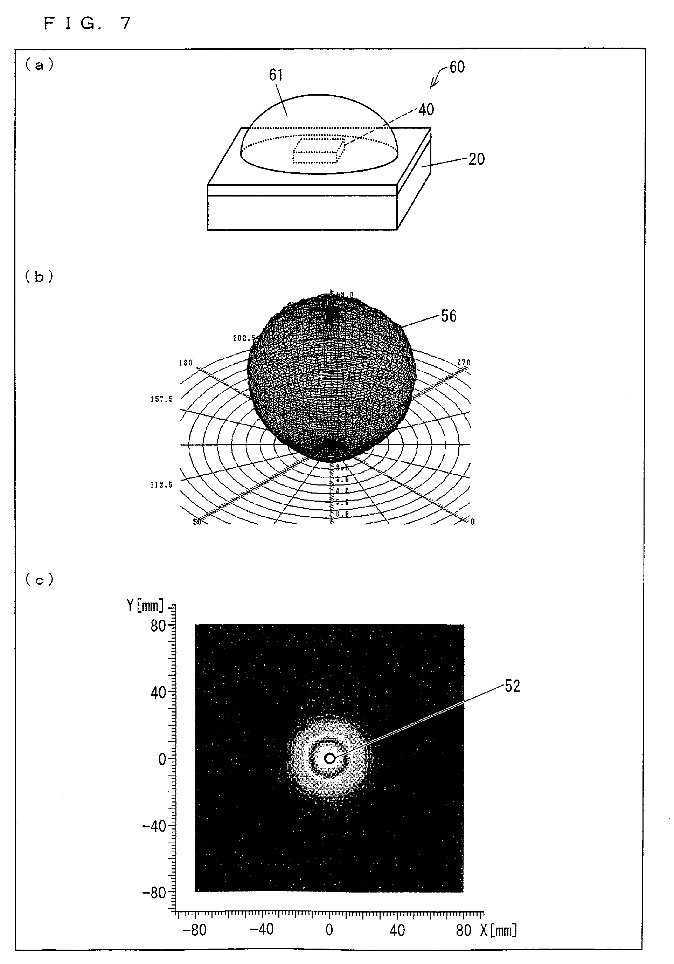

   Fig. 7 shows the shape, light-distribution characteristics, and illumination profile of a domed light-emitting device, (a) being a perspective view of the domed light-emitting device, (b) being a simulation diagram three-dimensionally showing the light-distribution characteristics of the domed light-emitting device, (c) being a simulation diagram showing the illumination profile of the domed light-emitting device.
Fig. 8

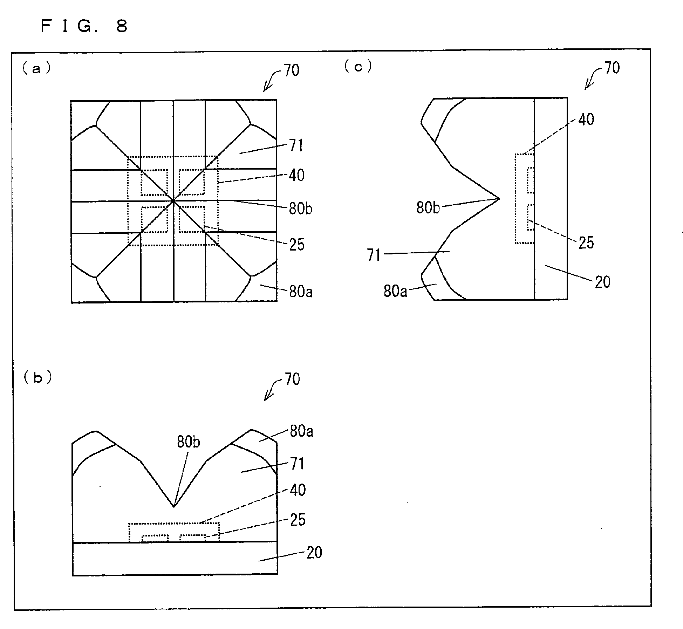

   Fig. 8 shows the shape of a cloverleaf light-emitting device, (a) being a plan view of the cloverleaf light-emitting device, (b) being a front view of the cloverleaf light-emitting device, (c) being a side view of the cloverleaf light-emitting device.
Fig. 9

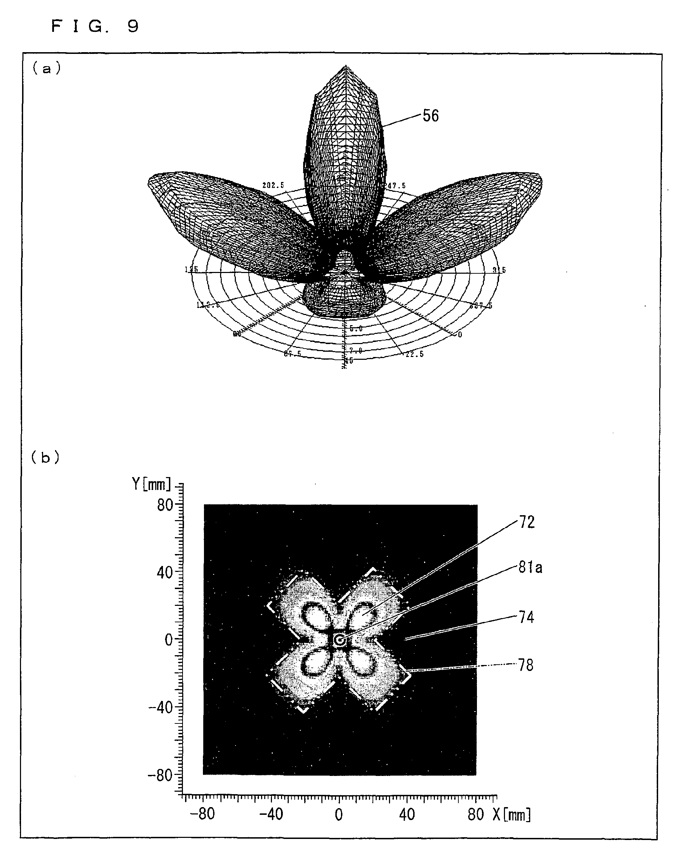

   Fig. 9 shows the light-distribution characteristics and illumination profile of the cloverleaf light-emitting device, (a) being a simulation diagram three-dimensionally showing the light-distribution characteristics of the cloverleaf light-emitting device, (b) being a simulation diagram showing the illumination profile of the cloverleaf light-emitting device.
Fig. 10

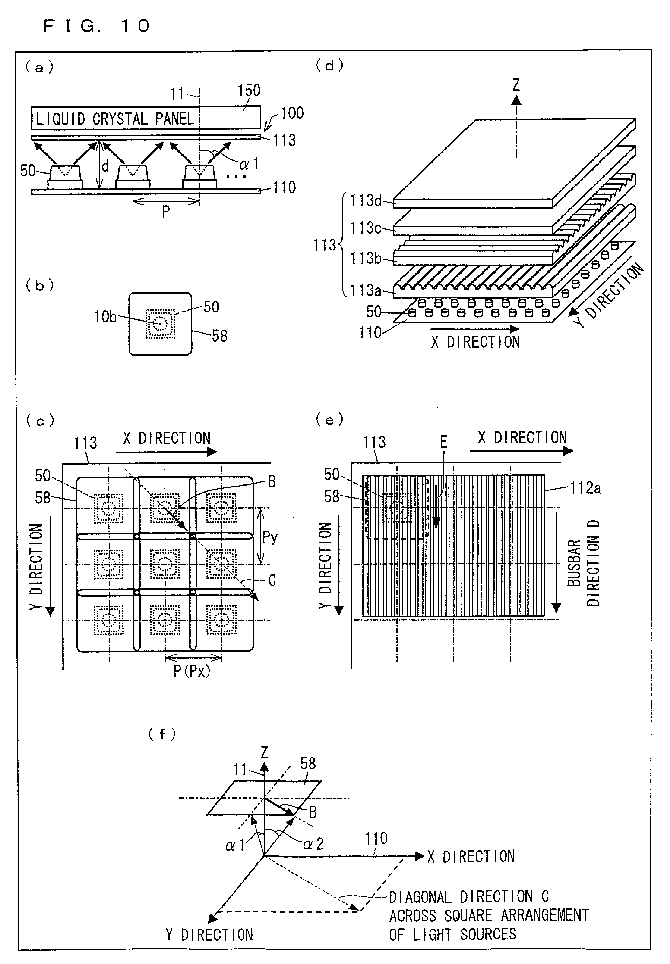

   Fig. 10 shows a schematic diagram of a planar light source according to an embodiment of the present invention, the illumination profile of a mortar-shaped light-emitting device, and a pattern of arrangement of mortar-shaped light-emitting devices, (a) being a side view of a display device according to the embodiment of the present invention, (b) being a schematic diagram showing correspondence between a mortar-shaped light-emitting device according to the embodiment of the present invention and the illumination profile, (c) being a plan view showing an arrangement of mortar-shaped light-emitting devices according to the embodiment of the present invention and the illumination profiles of them as a planar light source, (d) being a perspective view showing an arrangement of unevenness eliminating sheets and luminance improving films for use in a planar light source according to the embodiment of the present invention, (e) being a plan view showing that the busbar direction of the lens structure of an unevenness eliminating sheet and the direction of one side of a rectangular light-distribution pattern are parallel to each other in a planar light source according to the embodiment of the present invention, (f) being a perspective view explaining a gap in a light source array along a diagonal direction can be filled in a planar light source according to the embodiment of the present invention.
Fig. 11

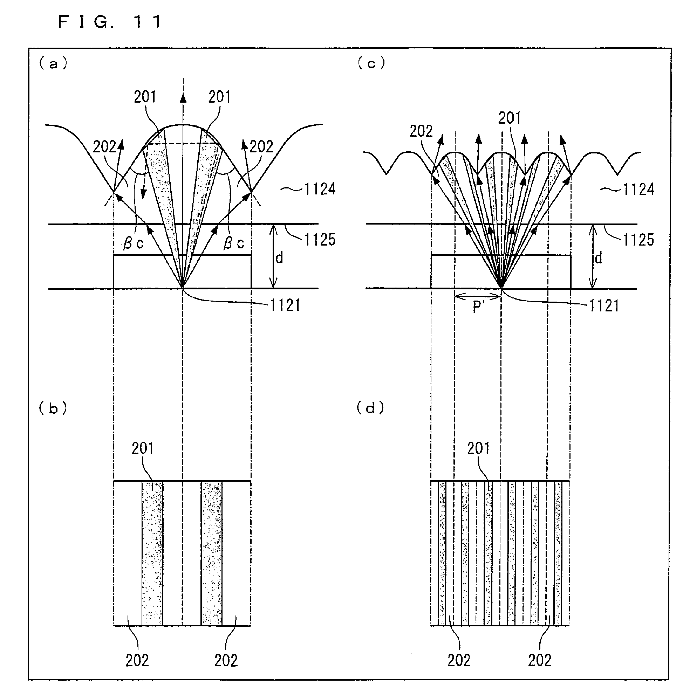

   Fig. 11 shows cases of optical sheets each having a lenticular structure, (a) and (c) each being a front view showing an arrangement of a point light source and the optical sheet and the direction of emission of light, (b) and (d) each being a plan view showing a pattern of emission as seen from above the optical sheet.
Fig. 12

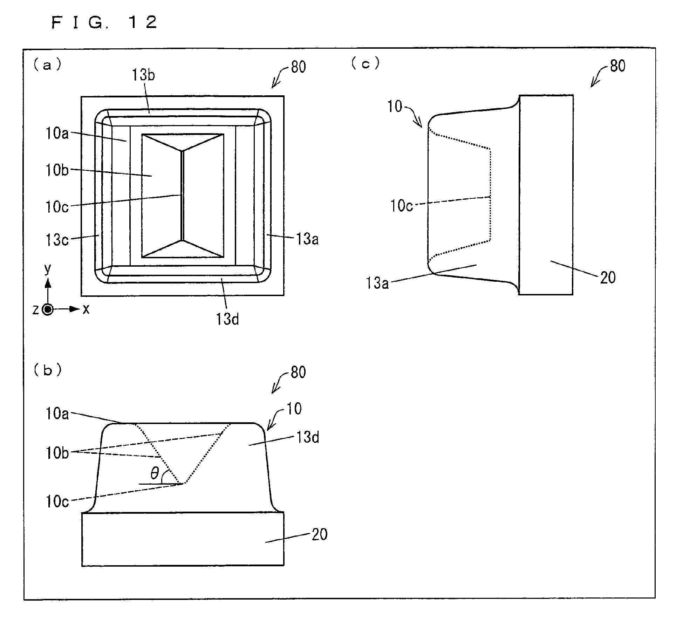

   Fig. 12 shows explanatory diagrams (a) to (c) explaining a wedge-shaped light-emitting device according to another embodiment of the present invention, (a) being a plan view of the wedge-shaped light-emitting device according to the embodiment of the present invention, (b) being a front view of the wedge-shaped light-emitting device according to the embodiment of the present invention, and (c) being a side view of the wedge-shaped light-emitting device according to the embodiment of the present invention.
Fig. 13

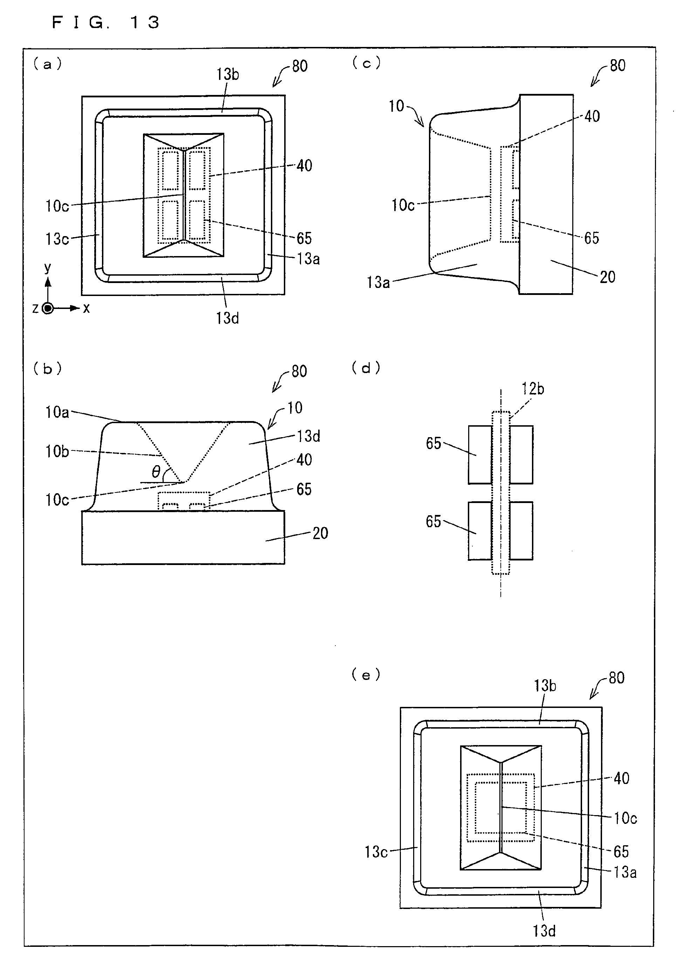

   Fig. 13 shows explanatory diagrams (a) to (e) explaining a wedge-shaped light-emitting device according to another embodiment of the present invention, (a) being a plan view showing an internal structure of the wedge-shaped light-emitting device according to the embodiment of the present invention, (b) being a front view showing the internal structure of the wedge-shaped light-emitting device according to the embodiment of the present invention, (c) being a side view of the wedge-shaped light-emitting device according to the embodiment of the present invention, (d) being an enlarged view of long LED chips and an area therearound in the wedge-shaped light-emitting device according to the embodiment of the present invention, (e) being a plan view showing one long LED chip being die-bonded to a position directly below the vertex of the letter V in the wedge-shaped light-emitting device according to the embodiment of the present invention.
Fig. 14

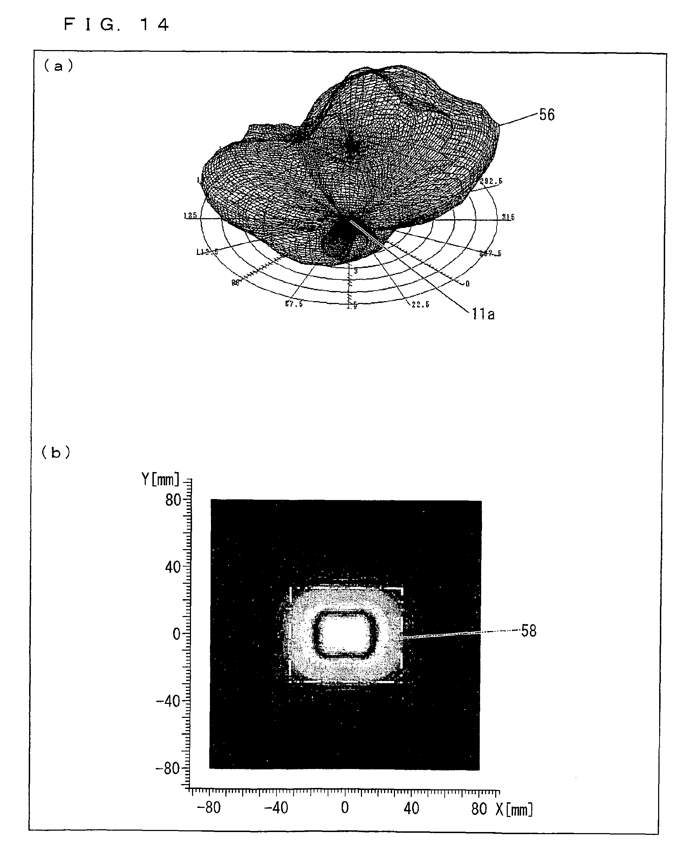

   Fig. 14 shows the light-distribution characteristics and illumination profile of a wedge-shaped light-emitting device according to another embodiment of the present invention, (a) being a simulation diagram three-dimensionally showing the light-distribution characteristics of the wedge-shaped light-emitting device according to the embodiment of the present invention, (b) being a simulation diagram showing the illumination profile of the wedge-shaped light-emitting device according to the embodiment of the present invention.
Fig. 15

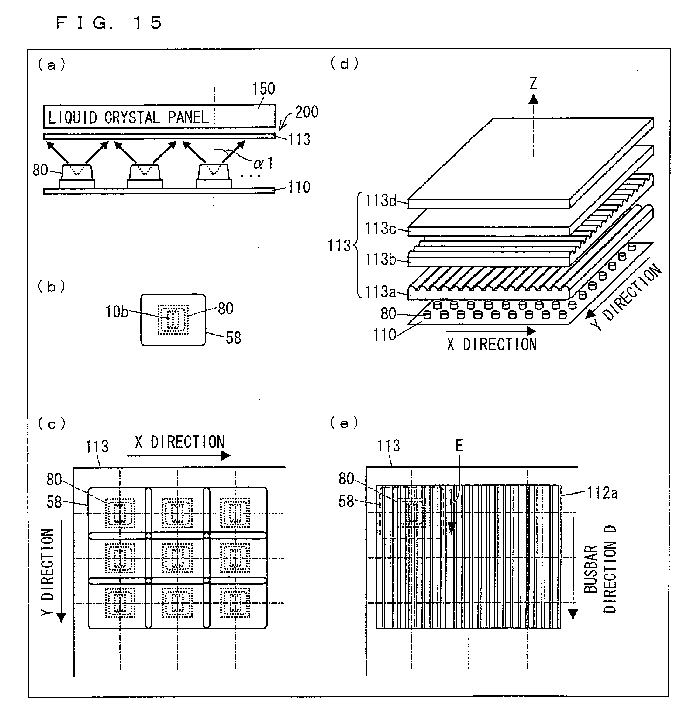

   Fig. 15 shows a schematic diagram of a planar light source according to another embodiment of the present invention and a pattern of arrangement of wedge-shaped light-emitting devices, (a) being a side view of a display device according to the embodiment of the present invention, (b) being a schematic diagram showing correspondence between a wedge-shaped light-emitting device according to the embodiment of the present invention and the illumination profile, (c) being a plan view showing an arrangement of wedge-shaped light-emitting devices according to the embodiment of the present invention and the illumination profiles of them as a planar light source, (d) being a perspective view showing an arrangement of unevenness eliminating sheets and luminance improving films for use in a planar light source according to the embodiment of the present invention, (e) being a plan view showing that the busbar direction of the lens structure of an unevenness eliminating sheet and the direction of one side of a rectangular light-distribution pattern are parallel to each other in a planar light source according to the embodiment of the present invention.
Fig. 16

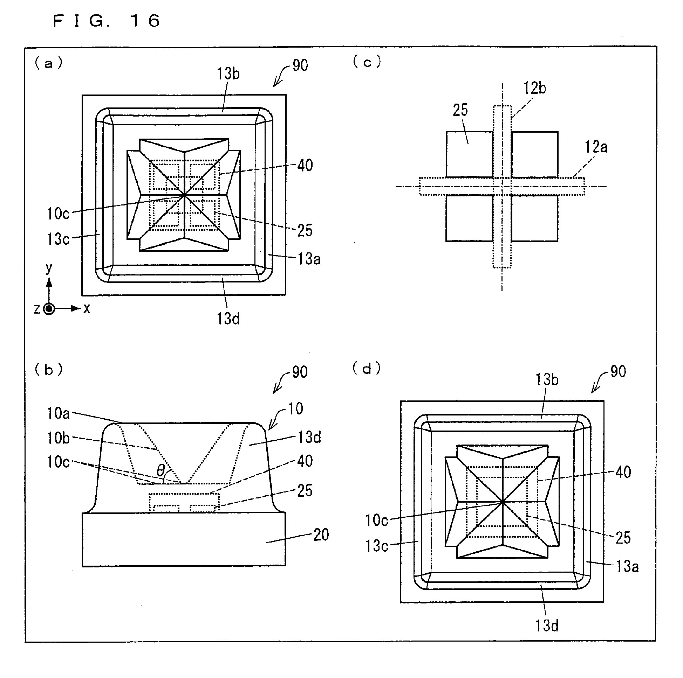

   Fig. 16 shows explanatory diagrams (a) to (d) explaining a light-emitting device according to still another embodiment of the present invention, (a) being a plan view showing an internal structure of the light-emitting device according to the embodiment of the present invention, (b) being a front view showing the internal structure of the light-emitting device according to the embodiment of the present invention, (c) being an enlarged view of LED chips and an area therearound in the light-emitting device according to the embodiment of the present invention, (d) being a plan view showing one LED chip being die-bonded to a position directly below the vertex of the letter V in the light-emitting device according to the embodiment of the present invention.
Fig. 17

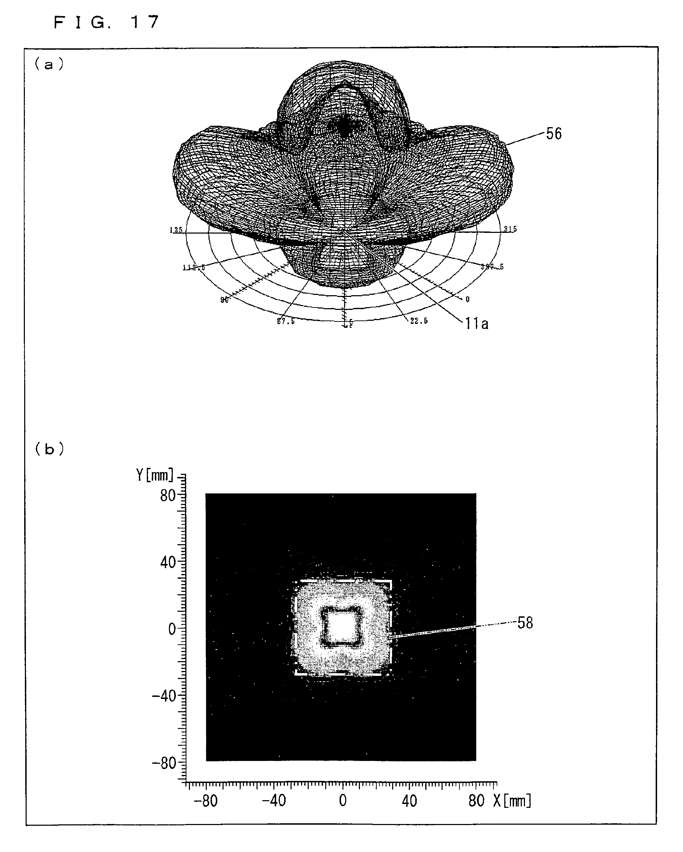

   Fig. 17 shows the light-distribution characteristics and illumination profile of a light-emitting device according to still another embodiment of the present invention, (a) being a simulation diagram three-dimensionally showing the light-distribution characteristics of the light-emitting device according to the embodiment of the present invention, (b) being a simulation diagram showing the illumination profile of the light-emitting device according to the embodiment of the present invention.
Fig. 18

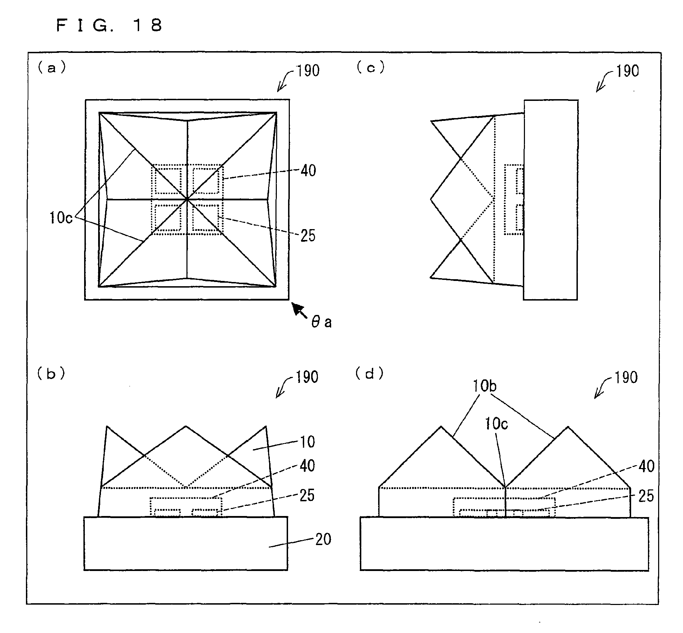

   Fig. 18 shows explanatory diagrams (a) to (d) explaining a light-emitting device according to still another embodiment of the present invention, (a) being a plan view of the light-emitting device according to the embodiment of the present invention, (b) being a front view of the light-emitting device according to the embodiment of the present invention, and (c) being a side view of the light-emitting device according to the embodiment of the present invention, (d) being a side view of the light-emitting device according to the embodiment of the present invention as seen from an oblique angle of 45 degrees (from an angle θa).
Fig. 19

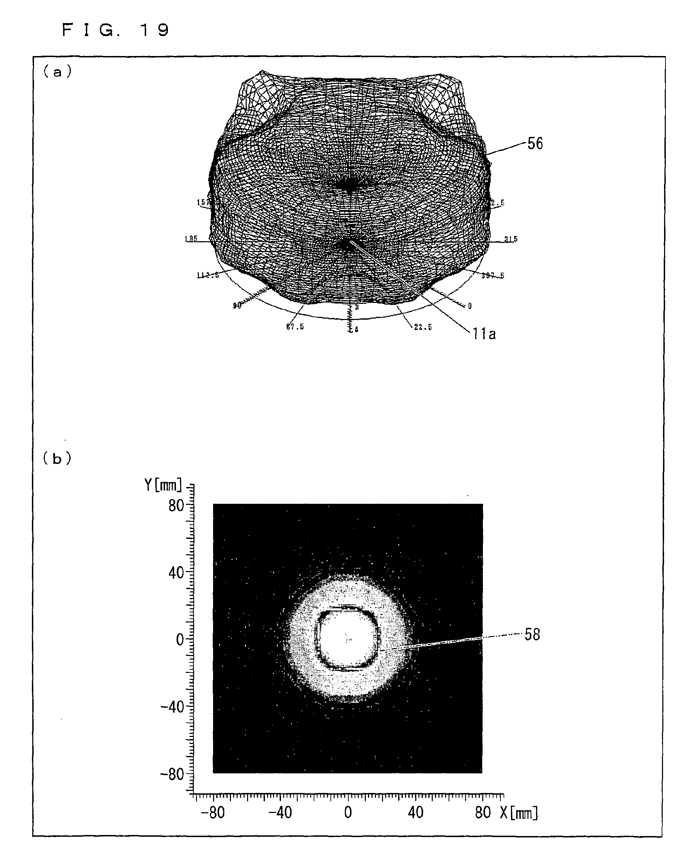

   Fig. 19 shows the light-distribution characteristics and illumination profile of a light-emitting device according to still another embodiment of the present invention, (a) being a simulation diagram three-dimensionally showing the light-distribution characteristics of the light-emitting device according to the embodiment of the present invention, (b) being a simulation diagram showing the illumination profile of the light-emitting device according to the embodiment of the present invention.
Fig. 20

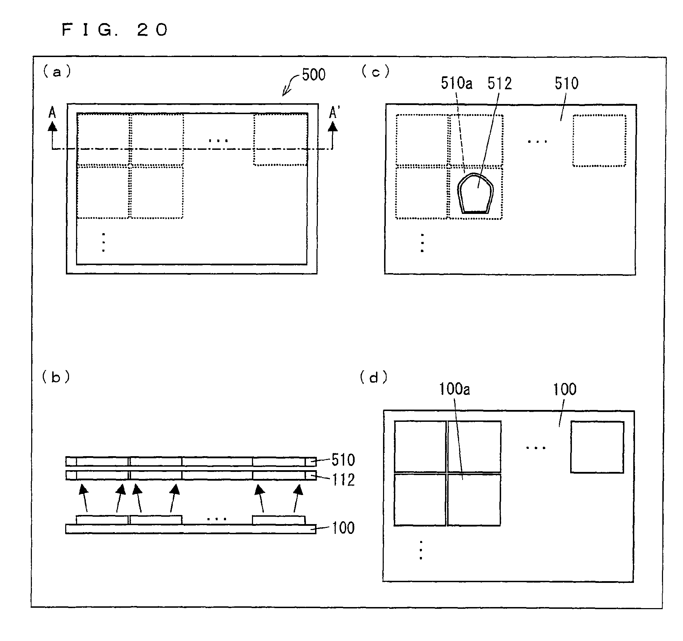

   Fig. 20 shows schematic diagrams (a) to (d) showing an area active (local dimming) liquid crystal display device, (a) being a plan view of the area active (local dimming) liquid crystal display device, (b) being a transverse cross-sectional view of the area active (local dimming) liquid crystal display device as taken along the line A-A', (c) and (d) showing a positional relationship between regions into which the display panel has been divided and those into which the planar light source has been divided.
Fig. 21
   Fig. 21 is a front view of a conventional LED package.
Fig. 22

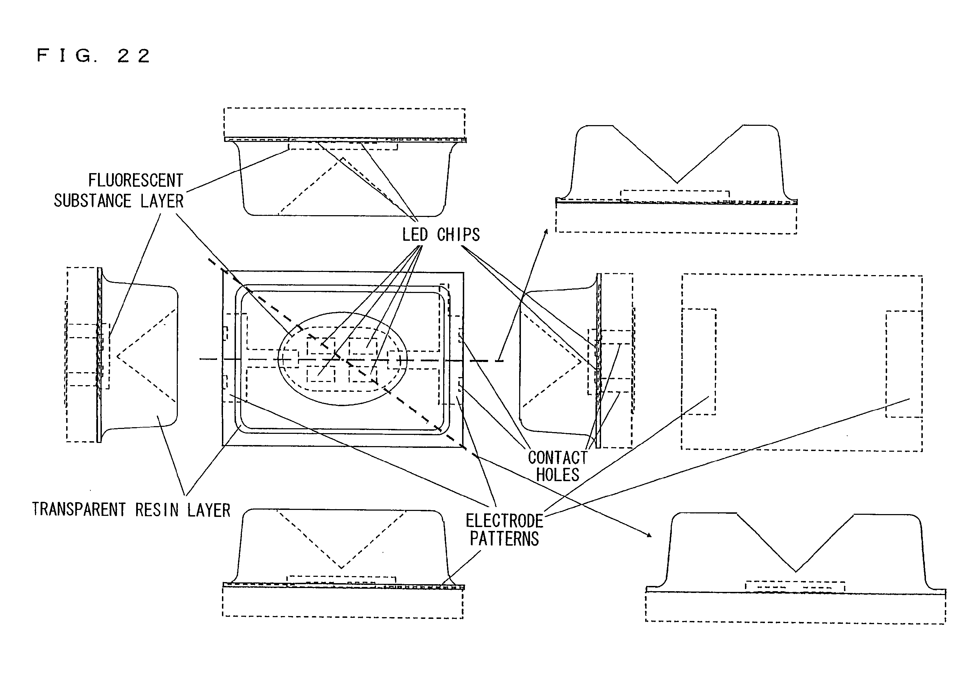

   Fig. 22 shows a top view and a side view of a light-emitting device of Additional Embodiment 1.
Fig. 23

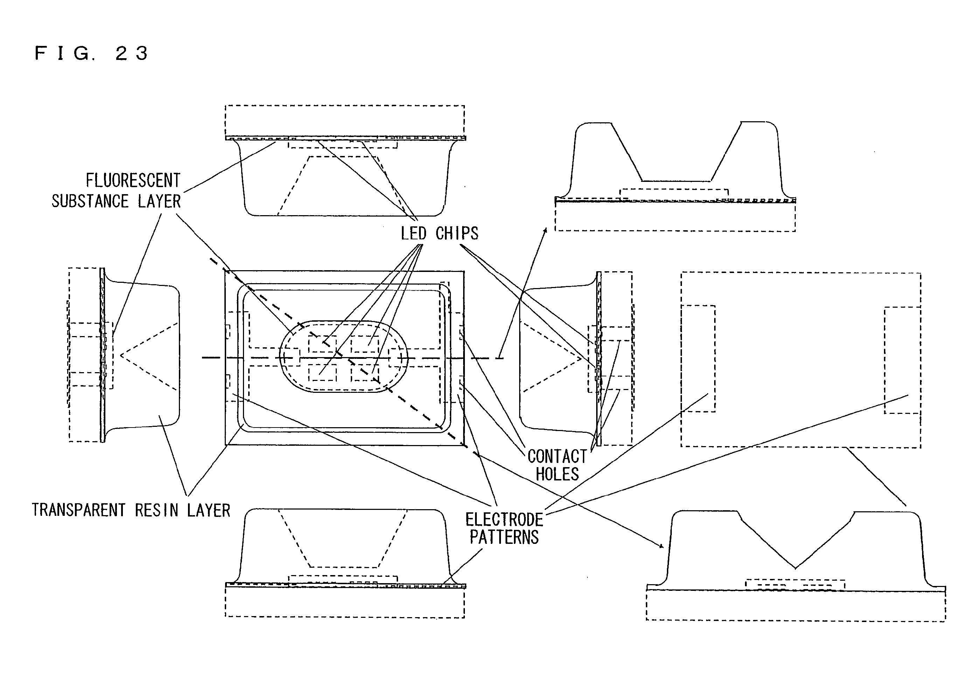

   Fig. 23 shows a top view and a side view of a light-emitting device of Additional Embodiment 2.

### Description of Embodiments

### (Embodiment 1)

An embodiment of the present invention is described below with reference to Figs. 1 through 10.

### (Light-emitting Device)

Fig. 1 shows explanatory diagrams explaining a mortar-shaped light-emitting device 50 according to Embodiment 1. (a) of Fig. 1 is a plan view of the mortar-shaped light-emitting device 50 according to Embodiment 1. (b) of Fig. 1 is a front view of the mortar-shaped light-emitting device 50 according Embodiment 1. (c) of Fig. 1 is a side view of the mortar-shaped light-emitting device 50 according to Embodiment 1.

Fig. 2 shows explanatory diagrams explaining the mortar-shaped light-emitting device 50 according to Embodiment 1. (a) of Fig. 2 is a plan view showing an internal structure of the mortar-shaped light-emitting device 50 according to Embodiment 1. (b) of Fig. 2 is a front view showing the internal structure of the mortar-shaped light-emitting device 50 according to Embodiment 1. (c) of Fig. 2 is a plan view showing space areas 12a and 12b between four LED chips 12, a central space area 12c, and a vertex 10c in the mortar-shaped light-emitting device 50 according to Embodiment 1. The central space area 12c is an area of overlap between the two space areas 12a and 12b in (c) of Fig. 12. The space area 12a is a rectangular area which passes through a point of intersection between a main axis 11 and a surface of a substrate 20 having a square shape and which, as will be described later, has its longer sides parallel to and its shorter sides perpendicular to one side of the substrate 20 when viewed planimetrically. The space area 12b is out of angle with the space area 12a by 90 degrees with the main axis 11 as a central point of rotation. In Embodiment 1, each of the LED chips, mounted on the substrate 20, which each have a rectangular shape when viewed planimetrically, has one side parallel to the longer sides of the space area 12a or 12b, and the length of each of the shorter sides of the space area 12a or 12b is equal to the space distance between LED chips disposed with the space area 12a or 12b therebetween. (d) of Fig. 2 is a plan view showing one LED chip 25 being die-bonded to a position of intersection between the substrate 20 and the main axis 11 in the mortar-shaped light-emitting device 50 according to Embodiment 1.

The mortar-shaped light-emitting device 50 has such features in appearance that it includes four side surfaces 13a, 13b, 13c, and 13d that keep in an upright position a sealing lens 10 covering the LED chips 12, that the sealing lens 10 has a top surface 10a having a quadrangular shape when viewed planimetrically, and that the top surface 10a has a concavely sunken part located above a substantially central part of the substrate 20. The concavely sunken part has a substantially conical shape formed in rotation symmetry about the main axis 11. It should be noted here that the main axis 11 is the central axis of the shape of the sealing lens 10 and, in the present invention, coincides with the arrangement of semiconductor light-emitting elements (hereinafter referred to as "LED chips 25") to be described later and the central axis of the illumination profile (intensity distribution of emitted light on a virtual view plane) of each semiconductor light-emitting element. It should also be noted that the conical shape may be replaced by a truncated conical shape, a polygonal conical shape, or a truncated polygonal conical shape.

A configuration of the mortar-shaped light-emitting device 50 is described below. The mortar-shaped light-emitting device 50 includes the substrate 20, the LED chips 25 die-bonded to the substrate 20, a wavelength conversion section 40 covering the LED chips 25, and the sealing lens 10 covering the wavelength conversion section 40. The sealing lens 10, formed directly on the wavelength conversion section 40, serves also as a sealing body and, as such, contributes to a reduction in size of the mortar-shaped light-emitting device 50 and has a sufficient strength. Alternatively, it is possible to provide a gap between the sealing lens 10 and the wavelength conversion section 40 (in which case the lens 10 no longer serves also as a sealing body). In particular, it is possible to shape the gap in such a way as to adjust light-distribution characteristics by refracting light.

For example, the typical dimensions of the mortar-shaped light-emitting device 50 are as follows: the substrate 20 is 3.2 mm on a side; the sealing lens 10 is 2.8 mm on a side and 1.6 mm in height; and each of the LED chips 25 is 0.4 mm on a side and 0.1 mm in height.

The substrate 20 preferably has a flat surface, is made of a material such as ceramic, resin, or metal, and has electrodes (not illustrated) formed on the surface or an inner part thereof to supply electrical power to the LED chips 25. The LED chips 25 are nitride semiconductor light-emitting elements and emit primary light which is blue light having its luminescence peak in a blue light wavelength range of 400 nm to 500 nm, for example.

The LED chips 25 are die-bonded to the substrate 20 with brazing filler metal, an adhesive, or the like, and each have positive and negative electrodes provided on its surface and electrically connected by wire bonding to two electrodes (not illustrated) provided on the substrate 20, respectively. The LED chips 25 can be mounted on the substrate by flip chip bonding instead of wire bonding. That is, the positive and negative electrodes formed on the surface of each LED chip 25 can be electrically connected to two electrodes formed on the substrate surface, respectively, with the surface of each LED chip 25 facing the substrate surface. Alternatively, it is possible to use an LED chip having positive and negative electrodes disposed on both surfaces thereof, respectively, in which case the positive electrode can be connected to an electrode on the substrate by wire bonding and the negative electrode can be connected to an electrode on the substrate surface with a conductive bonding material or the like.

Next, the wavelength conversion section 40 is formed by covering the LED chips 25 with a resin in which a fluorescent substance has been dispersed in advance. The fluorescent substance is a substance that absorbs the primary light emitted by the LED chips 25 and emit secondary light which is yellow light having its luminescence peak in a yellow light wavelength range of 550 nm to 600 nm, for example. The mortar-shaped light-emitting device 50 is configured to emit white light, which is a mixture of the primary light and the secondary light.

It should be noted that suitably usable examples of the fluorescent substance include BOSE (Ba, O, Sr, Si, Eu), etc. Other suitably usable examples than BOSE include SOSE (Sr, Ba, Si. O, Eu), YAG (Ce-activated yttrium · aluminium · garnet), α sialon ((Ca), Si, Al, O, N, Eu), β sialon (Si, Al, O, N, Eu), etc.

Further, the LED chips 25, which emit blue light, may be replaced by LED chips that emit ultraviolet (near-ultraviolet) light having its luminescent peak wavelength falling within a range of 390 nm to 420 nm. This brings about a further improvement in luminous efficiency.

Further, for better color reproducibility, the yellow fluorescent substance may be replaced by a combination of a red fluorescent substance and a green fluorescent substance. Suitably usable examples of the red fluorescent substance include CASN (CaAlSiN₃; Eu-activated), etc., and suitably usable examples of the green fluorescent substance include β sialon (Si, Al, O, N, Eu), BOSE (Ba, O, Sr, Si, Eu), etc.

Then, the wavelength conversion section 40 is covered with the sealing lens 10. The sealing lens 10 is made of a material, such as epoxy resin or silicone resin, which is capable of transmitting emitted light, and also functions as a prism that directs emitted light in a predetermined direction. It should be noted that the wavelength conversion section 40 may be made of a base material that is either the same resin as the resin of which the sealing lens 10 is made, or a resin which is equal in refractive index to or greater in refractive index than the resin of which the sealing lens 10 is made.

The sealing lens 10 includes four side surfaces 13a, 13b, 13c, and 13d standing upright, and has a quadrangular contour when viewed planimetrically. These side surfaces are almost flat, but do not necessarily need to be completely flat. As shown in (b) and (c) of Fig, 1, each of these side surfaces is not perpendicular to the substrate but has an inclination that gets nearer slightly to the center as it extends upward. This brings about such an advantage that it is easy to die-cut the sealing lens 10 in the case of resin molding of the sealing lens 10 with use of a mold. It should be noted that since light that passes through the side surface refracts, the illumination profile on a plane at a given distance from the light-emitting device can be narrowed as a whole or, on the other hand, the illumination profile can be widened by appropriately adjusting the slope. Therefore, the angles of inclination of the side surfaces 13a, 13b, 13c, and 13d are determined in consideration of broadening of light distribution and uniformity of light distribution.

Further, the sealing lens 10 has the top surface 10a, which is flat, and the sunken part, placed in a central part of the top surface 10a (preferably on the main axis 11), which includes a mortar-shaped (or, preferably, conical-shaped) slope 10b. It is preferable that the slope 10b have a truncated conical shape, a polygonal conical shape, or a truncated polygonal conical shape, as well as a conical shape. Further, the shape of the sunken part does not need to be in axial symmetry about the main axis 11, and can be changed appropriately for optimization of the light-distribution characteristics. For ease of production and a continuous distribution of illumination, it is preferable that a joint between one of the side surfaces 13a, 13b, 13c, and 13d and another and a joint between each of them and the ceiling surface 10a be smooth.

Concern that arises in a case where the light-emitting section is covered with the sealing lens 10, which is a cuboid sealing resin, is that the efficiency of extraction of light decreases due to total reflection that occurs at the boundary surface between an outer surface of the sealing lens 10 or, in particular, the slope 10b constituting the sunken part and air. However, as seen in the mortar-shaped light-emitting device 50 of Embodiment 1, the same level of efficiency of extraction of light as in the after-mentioned domed light-emitting device 60 can be achieved by placing, in the central part of the sealing lens 10, a comparatively large concavely sunken part having an inclined surface and by setting the height of the sealing lens 10 greater by at least one third or, more preferably, one half than the width of the sealing lens 10.

It should be noted here that, as shown in (a) of Fig. 2, a total of four LED chips 25 are die-bonded to the respective vertices of an imaginary square 24 centered at the main axis 11 and indicted by a chain double-dashed line on the surface of the substrate 20. It should also be noted here that the vertex 10c of the mortar-shaped slope 10b, formed on the top surface 10a of the sealing lens 10, is in such a position that the main axis 11 passes through the vertex 10c. Further, the point of intersection 12 between two lines PP and QQ, indicated by chain double-dashed lines, which pass through the center of the space area 12a between two adjacent LED chips 25 and the center of the space area 12b between two adjacent LED chips 25 is similarly in such a position that the main axis 11 passes through the point of intersection 12. That is, when viewed planimetrically in (a) of Fig. 2, the vertex 10c and the point of intersection 12 coincide substantially with each other.

Such a configuration allows the position of the vertex 10c as viewed planimetrically in (c) of Fig. 2 to fall within the central space area 12 among the LED chips as shown in (c) of Fig. 2 so that the four LED chips 25 are arranged substantially evenly on all four sides with respect to the mortar-shaped slope 10b, even if the die-bonding position of the LED chips 25 is slightly displaced along the x direction or the y direction or, even if, in the case of molding of the sealing lens 10, the position of the mortar-shaped slope 10b is slightly displaced along the x direction or the y direction. For this reason, the resulting light-distribution characteristics of the mortar-shaped light-emitting device 50 is stably high in plane symmetry about a plane obtained by extending the lines PP and QQ along a direction perpendicular to the substrate.

More specifically, as shown in (b) of Fig. 2, the mortar-shaped slope 10b, when viewed in cross-section, is constituted by two slopes with the vertex 10c interposed therebetween. Therefore, it is necessary to consider for each separate slope the reflection and refraction characteristics of incident light emitted by the LED chips 25. In other words, the two slopes are equal in angle of inclination and therefore equal in reflection and refraction characteristics with respect to the angle of incidence of light, but require consideration of the fact that they are bilaterally symmetrical with each other. In a case where a single LED chip 25 is placed directly below the vertex 10c, there is an increase in amount of incident light on that one of the mortar-shaped slopes directly below which the center of the LED chip 25 comes when the LED chip 25 shifts in one direction with respect to the vertex 10c, whereas there is a decrease in amount of incident light on that one of the mortar-shaped slopes directly below which the center of the LED chip 25 does not come. This is because that one of the mortar-shaped slopes directly below which the center of the LED chip 25 comes casts a shadow. As a result, there is likely to be disruption of a balance of extraction of light between the two slopes. On the other hand, in a case where separate LED chips are placed directly below the two slopes, light emitted by the LED chip placed directly below one of the slopes mostly does not enter the other, thus exerting little influence. Moreover, even if the LED chip located directly below one of the slopes shifts rightward or leftward, three will be no change in angle of incidence of light emitted by the LED chip to the slope, unless the LED chip goes beyond the vertex 10c, with the slope 10b having a fixed angle of inclination. Therefore, there will be little disruption of a balance of extraction of light between the two slopes.

In summary, in a case where the LED chips, when viewed in cross-section, are placed together directly below one of the slopes in avoidance of being directly below the vertex 10c or placed separately directly below the two slopes, there is unlikely to be disruption of a balance of extraction of light between the two slopes as the light-emitting device, even if the LED chips are displaced with respect to the vertex 10c to such an extent that the LED chips do not pass transversely across the vertex 10c.

It should be noted that the foregoing presupposes that the wavelength conversion section 40 is displaced in accordance with the displacement of the LED chips 25.

Further the LED chips 25 are surrounded by the wavelength conversion section 40 containing the fluorescent substance in the form of particles. Part (primary light) of the light emitted from the LED chips 25 is absorbed by the fluorescent substance, and the secondary light, which is longer in wavelength than the primary light, is emitted isotropically. Another part of the light emitted from the LED chips 25 is scattered by the fluorescent substance, and still another part of the light emitted from the LED chips 25 is transmitted without being absorbed or scattered. Therefore, the particles of the fluorescent substance per se serve point-like light sources, and it is necessary to consider the influence exerted thereby. However, emitted light and scattered light that originate from the particles of the fluorescent substance are greatly affected by the light emitted from an LED chip located nearer to the particles of the fluorescent substance, the influence on extraction of light by displacement of an LED chip tends roughly to be as described above.

It should be noted here that the central space area 12c among the LED chips 25 is an area of intersection between the two space areas 12a and 12b between the LED chips 25.

It should be noted that the mortar-shaped light-emitting device 50 may be configured such that, as shown in (d) of Fig. 2, a single LED chip 25 is die-boned to a position of intersection between the substrate 20 and the main axis 11. In this case, it is essential to distribute light evenly in four directions by strictly managing manufacturing so that the center of the LED chip 25 intersects with the main axis 11. For this reason, the degree of difficulty with which products of the same light-distribution characteristics are stably produced is higher than in the case where the four LED chips 25 are disposed evenly as shown in (a) of Fig. 2.

Further, due to problems of processing accuracy, it is difficult to make the vertex 10c of the mortar shape in the form of an ideal vertex, i.e., a sharp-pointed shape, and the placement of an LED chip 25 as shown in (d) of Fig. 2 causes a problem of leakage of light upward along the axis. For this reason, it is especially preferable, for realization of stable characteristics in production, that the mortar-shaped light-emitting device 50 be structured such that such LED chips 25 as those shown in (a) of Fig. 2 are arrayed in a position displaced from the vertex 10c.

While Fig. 2 has shown a case of arrangement of four LED chips 25, Fig. 3 shows a case of arrangement of three LED chips. Fig. 3 shows explanatory diagrams explaining a mortar-shaped light-emitting device 121 according to Embodiment 1. (a) of Fig. 3 is a plan view showing an internal structure of the mortar-shaped light-emitting device 121 according Embodiment 1. (b) and (c) of Fig. 3 are each an enlarged view of LED chips and an area therearound in the mortar-shaped light-emitting device 121 according to Embodiment 1. The LED chips 25 may be arranged as shown in (c) of Fig. 3, but light distribution is more stable when the LED chips 25 are arranged as shown in (b) of Fig. 3. Therefore, for the purpose of production, it is more preferable that the LED chips 25 be arranged as shown in (b) of Fig. 3.

Fig. 4 shows explanatory diagrams explaining a mortar-shaped light-emitting device 122 according to Embodiment 1. (a) of Fig. 4 is a plan view showing an internal structure of a modification of arrangement of LED chips in the mortar-shaped light-emitting device 122 according to Embodiment 1, with two LED chips mounted. (b) to (d) of Fig. 4 are each an enlarged view of LED chips and an area therearound in the mortar-shaped light-emitting device 122 according to Embodiment 1, and each showing the arrangement of LED chips in (a) of Fig. 4 or a modification of arrangement of LED chips different from that shown in (a) of Fig. 4.

In (a) and (b) of Fig. 4, the LED chips are arranged so that each of the LED chips has one side extending along the same longer side of the same space area 12b as that shown in Fig. 2, and that each of the LED chips has another side, orthogonal to that one side, which extends along the opposite longer sides of the space area 12a, respectively, and that the space area 12a lies between the LED chips.

In (c) of Fig. 4, the LED chips are arranged so that each of the LED chips has one side extending along the opposite longer sides of the space area 12a or 12b, respectively, and has another side, orthogonal to that one side, which extends along the opposite longer sides of the space area 12a or 12b, respectively, that the space area 12a or 12b lies between the LED chips, that the LED chips get lined up diagonally across the substrate, and that the LED chips are in centrosymmetry with each other about the main axis 11.

In (d) of Fig. 4, the LED chips are arranged so that each of the LED chips has one side extending along the opposite longer sides of the space area 12a, respectively, that the space area 12a lies between the LED chips, and each of the LED chips has another side, orthogonal to that one side, which is parallel to a line perpendicular to the longer sides of the space area 12a.

Furthermore, the LED chips are arranged so that a line passing through the main axis 11 perpendicularly to the longer sides of the space area 12a passes through the center of each of the LED chips.

The LED chips 25 may be arranged as shown in (d) of Fig. 4, but as shown in (b) of Fig. 2, light distribution is more stable when the LED chips 25 are arranged as shown in (b) or (c) of Fig. 4. Therefore, for the purpose of production, it is more preferable that the LED chips 25 be arranged as shown in (b) or (c) of Fig. 4.

It should be noted that although each of the LED chips used has a square shape when viewed planimetrically, each of the LED chips used may have an oblong shape, and for the purpose of making the wavelength conversion section 40 smaller, such oblong LED chips 25 may for example be arranged so that their longer sides run parallel. For example, (d) of Fig. 3 is a plan view of an example of arrangement of three rectangular LED chips 25, and (e) of Fig. 3 is a plan view of an example of arrangement of four rectangular LED chips 25. The LED chips 25 are arranged in parallel with one another along the line PP that passes through the center of each of the LED chips 25.

Further, it is preferable that the wavelength conversion section 40, composed of a translucent resin containing a fluorescent substance dispersed in advance therein, which covers the LED chips 25 have such a size that the wavelength conversion section 40 falls within an opening in the mortar-shaped slope 10b (where the ceiling surface and the slope meet). This allows a reduction in that component of light from the wavelength conversion section 40 (i.e., of light emitted by the LED chips 25 and light emitted from the fluorescent substance dispersed in the wavelength conversion section 40) which exits directly through the ceiling surface 10a and travels toward an area directly above the light-emitting device, thus allowing an increase in light that enters the slope 10b. This allows much of the light to be reflected by the slope 10b and guided toward the side walls13a to 13b, thus achieving such a light-emitting device having wide-angle light-distribution characteristics as will be shown in (a) and (c) of Fig. 6 later.

Fig. 5 shows explanatory diagrams explaining a mortar-shaped light-emitting device 123 according Embodiment 1. (a) of Fig. 5 is a plan view showing an internal structure of the mortar-shaped light-emitting device 123 according to Embodiment 1. (b) and (c) of Fig. 5 are each an enlarged view of an LED chip and an area therearound in the mortar-shaped light-emitting device 123 according to Embodiment 1. The LED chips 25 may be placed as shown in (c) of Fig. 5, but light distribution is more stable when the LED chip 25 is placed as shown in (b) of Fig. 5. Therefore, for the purpose of production, it is more preferable that the LED chip 25 be arranged as shown in (b) of Fig. 5.

The issue of the position of the vertex 10c of the mortar shape along the horizontal direction of the substrate has been discussed thus far.

Next, the position of the vertex 10c of the mortar shape along the vertical direction of the substrate is discussed with reference to the front view shown in (b) of Fig. 2. It is desirable that the vertex 10c is as close as possible to the substrate 20 or the LED chips. Such an arrangement allows light from the LED chips 25 to be guided by the mortar-shaped slope 10b more effectively toward the four surfaces standing upright on the periphery of the sealing lens 10. This is because of an increase in the solid angle from which the mortar-shaped slope 10b is looked at from the LED chips 25.

However, it is desirable that the vertex 10c of the mortar shape not be in contact with the wavelength conversion section 40. This is because if the vertex 10c makes contact with or cuts into the wavelength conversion section 40, which contains the fluorescent substance, light excited by the fluorescent substance leaks from that part to increase the intensity of light on the axis.

In summary, it is desirable that the vertex 10c of the mortar shape be as close as possible to the substrate to such an extent so not to make contact with the wavelength conversion section 40.

Fig. 6 shows the light-distribution characteristics (dependence on the angle of radiation of an intensity distribution of emitted light) of the mortar-shaped light-emitting device 50 according to Embodiment 1, the illumination profile (intensity distribution of emitted light on a virtual view plane) of the mortar-shaped light-emitting device 50 according to Embodiment 1, and a method for evaluating the illumination profile of the mortar-shaped light-emitting device 50 according to Embodiment 1. (a) of Fig. 6 is a simulation diagram three-dimensionally showing the light-distribution characteristics of the mortar-shaped light-emitting device 50 according to Embodiment 1, and the intensity of emitted light is indicated by the distance from the center 11a to an outer edge surface 56.
(b) of Fig. 6 is a graph showing actual measurements of the light-distribution characteristics (dependence on the angle of radiation of an intensity distribution of emitted light) of a cross-section containing the vertical direction and the x direction and a cross-section containing the vertical direction and the B direction (obtained by rotating the x direction 45 degrees in the x-y plane), the cross-sections being cut out of the diagram showing the light-distribution characteristics of the mortar-shaped light-emitting device 50 according to Embodiment 1. These actual measurements correspond substantially to the simulation values shown in (a) of Fig. 6.

The angle of radiation (which is an angle formed with the vertical direction) at which the relative light intensity takes on a maximum value is α1, which is a minimum value at the cross-section containing the vertical direction and the x direction, and α2, which is a maximum value at the cross-section containing the vertical direction and the B direction (to be described later), and α2 is greater than α1, whereby a substantially rectangular illumination profile to be described later is achieved.

It should be noted that in (b) of Fig. 6, α1 is equal to 36 degrees and α2 is equal to 42 degrees. Further, the B direction is a diagonal direction across the rectangular illumination profile, and assuming that the rectangular shape is in the form of a square shape, the B direction is a direction obtained by rotating the x direction 45 degrees in the x-y plane.
(c) of Fig. 6 is a simulation diagram showing the illumination profile of the mortar-shaped light-emitting device 50 according to Embodiment 1. The term "illumination profile" here means an illumination profile obtained by illuminating a diffusing plate 112 as will be described later, and in (c) of Fig. 6, the chain double-dashed line indicates a contour line 58. As shown in (c) of Fig. 6, the illumination profile of the mortar-shaped light-emitting device 50 is nonconcentric and nonaxisymmetric and, in particular, forms a substantially rectangular (hereinafter simply referred to as "rectangular") illumination profile on the diffusing plate 112. In other words, there are four bright portions distributed along the B direction (diagonal direction).
(d) of Fig. 6 shows the method for evaluating the illumination profile of the mortar-shaped light-emitting device 50 according to Embodiment 1. The mortar-shaped light-emitting device 50 is mounted on a mounting substrate 110, with the diffusing plate 112 disposed to face the mounting substrate 110. When the mortar-shaped light-emitting device 50 illuminates the back surface of the diffusing plate 112, the illumination profile is observed on the front surface of the diffusing plate 112.

It should be noted that observations are made with a distance d of 18 mm from the mounting substrate 110 to the diffusing plate 112.

The illumination profile here indicates an intensity distribution of emitted light on a vertical view plane immediately before incidence on the diffusing plate 112. Meanwhile, the simulation diagram shown in (c) of Fig. 6 to show the illumination profile described in the present embodiment is one obtained by simulating an illumination profile on a view plane immediately before incidence on the diffusing plate 112.

For comparison, Fig. 7 shows the shape, light-distribution characteristics, and illumination profile of a domed light-emitting device. (a) of Fig. 7 is a perspective view of the domed light-emitting device 60, which includes a substrate 20, an LED chip 25 (not illustrated) die-bonded to the substrate 20, a wavelength conversion section 40 covering the LED chip 25; and a domed sealing body 61 covering the wavelength conversion section 40.
(b) of Fig. 7 is a simulation diagram three-dimensionally showing the light-distribution characteristics of the domed light-emitting device 60, and
(c) of Fig. 7 is a simulation diagram showing the illumination profile of the domed light-emitting device 60. These drawings show that the light-distribution characteristics of the domed light-emitting device 60 exhibits a spherical shape in the three-dimensional simulation diagram and the illumination profile is concentric with respect to a bright portion 52 appearing above the LED chip 25.

A comparison between the illumination profile of the mortar-shaped light-emitting device 50 and the illumination profile of the domed light-emitting device 60 shows that the mortar-shaped light-emitting device 50 illuminates a wider area than the domed light-emitting device 60 does.

For comparison, Figs. 8 and 9 shows the shape, light-distribution characteristics, and illumination profile of a cloverleaf light-emitting device 70. (a) of Fig. 8 is a plan view of the cloverleaf light-emitting device 70. (b) of Fig. 8 is a front view of the cloverleaf light-emitting device 70. (c) of Fig. 8 is a side view of the cloverleaf light-emitting device 70.

The cloverleaf light-emitting device 70 includes a substrate 20, four LED chips 25 die-bonded to the substrate 20, a wavelength conversion section 40 covering the LED chips 25 and containing a fluorescent substance dispersed therein, a block-like sealing body (sealing lens) 71 having four raised parts 80a covering the wavelength conversion section 40. As shown in the plan view of (a) of Fig. 8, the four raised parts 80a are formed by forming groove-like depressed parts 80b respectively extending vertically and horizontally. The depressed parts 80b are also shown in the front view of (b) of Fig. 8 and the side view of (c) of Fig. 8. Although the raised parts 80a gently slope down toward the four vertices of the cloverleaf light-emitting device 70 when viewed planimetrically, the raised parts 80a may be flat.
(a) of Fig. 9 is a simulation diagram three-dimensionally showing the light-distribution characteristics of the cloverleaf light-emitting device 70.
(b) of Fig. 9 is a simulation diagram showing the illumination profile of the cloverleaf light-emitting device 70. These drawings show that the illumination profile of the cloverleaf light-emitting device 70 is indicated by a contour line 78 indicated by a chain double-dashed line in (b) of Fig. 9, that those bright portions surrounded by the contour line 78 are bright portions 72 that are high in illuminance, and that those dark portions distributed near the bright portions 72 are dark portions 74 that are low in illuminance.

Thus, the illumination profile of the cloverleaf light-emitting device 70 is such that the four bright portions 72 and the four dark portions 74 are distributed in positions above the raised part 80a and positions above the depressed parts 80b, respectively. As a result, the illumination profile of the cloverleaf light-emitting device 70 exhibits the shape of the letter X with four-fold symmetry about the center 81a, as with the shape of the sealing body 71.

A comparison between the illumination profile of the mortar-shaped light-emitting device 50 and the illumination profile of the cloverleaf light-emitting device 70 shows that the cloverleaf light-emitting device 70 also illuminates those parts where the four dark portions 74 are formed. To the extent that the parts corresponding to the four dark portions 74 become brighter, the parts corresponding to the four bright portions 72 decrease in illuminance. As a result, the mortar-shaped light-emitting device 50 achieves such a substantially rectangular illumination profile that the parts corresponding to the four bright portions 72 in the illumination profile of the cloverleaf light-emitting device 70 serve as vertices.

It should be noted that although the sealing lens (mortar-shaped lens) 10 of the mortar-shaped light-emitting device 50 also serves to seal in the LED chips 25 and the wavelength conversion section 40, it is also possible to provide a mortar-shaped lens separately from a sealing body and mount it on an ordinary LED chip sealing body. In so doing, it is preferable, for the purpose of increasing the efficiency of extraction of light, that the space between the sealing body and the mortar-shaped lens be filled with another transparent resin or the like. However, it is also possible to provide the space without filling it with anything.

But yet, for the sake of simplicity of manufacture such as the capabilities of easily positioning the lens with high accuracy, increasing the efficiency of extraction of light, and finishing lens fabrication and resin sealing at the same time, it is most preferable that the mortar-shaped lens serves also as a sealing body as shown in Embodiment 1.

It should be noted that it is desirable that the angle of inclination θ of the mortar-shaped slope 10b be steeper than the critical angle θc of total reflection. Furthermore, it is desirable that the angle of inclination θ of the mortar-shaped slope 10b range from an angle approximately equal to the critical angle θc to 60 degrees. The term "total reflection" here assumes total reflection that occurs at the boundary between the sealing resin and the atmosphere, and in a case where the refractive index of the sealing resin is n, the critical angle θc of total reflection can be calculated according to arcsin (1/n). By increasing the angle of inclination θ of the mortar-shaped slope 10b to θc or lager, strong light emitted upward along the axis of each LED chip 25 or toward an area therearound can be effectively guided toward the four surfaces standing upright on the periphery of the sealing lens 10, and light having passed through these surfaces contributes to the formation of a substantially rectangular illumination profile.

On the other hand, if the angle of inclination θ is 60 degrees or larger, more components of the light emitted upward along the axis of each LED chip 25 are reflected by the slope and emitted toward the top surface 10a, and therefore can no longer be effectively guided toward the four surfaces standing upright on the periphery of the sealing lens 10. For this reason, even if the illumination profile is rectangular, it is no longer possible to obtain a sufficient area of illumination. Moreover, for entire coverage of the LED chips 25, an increase in the angle of inclination of the mortar-shaped slope leads to an increase in depth of the sunken part and an increase in height of the device, thus making fabrication difficult.

For this reason, it can be said to be desirable that the angle of inclination θ of the mortar-shaped slope 10b range from an angle approximately equal to the critical angle θc of total reflection to 60 degrees. In the case of use of a typical resin having a refractive index n of 1.5, the critical angle θc is 41.8 degrees.

Although the action of the slope 10b has been described mainly in terms of total reflection, the transmitted components also play an important role. Part of light emitted from the LED chips 25 or the wavelength conversion section 40 is transmitted through the slope 10b and the ceiling surface 10a toward an area directly above the LED chips 25 or the wavelength conversion section 40, or is transmitted with some refraction. This causes light to be distributed over an area directly above the main axis 11, and as shown in (a) and (c) of Fig. 6, the light-emitting device has such light-distribution characteristics that light is emitted widely over a predetermined large range of angles of inclination from a position directly above the main axis 11. Further, in order that light entering the ceiling surface 10a is refracted to change from traveling toward an area directly above the LED chips 25 or the wavelength conversion section 40 to traveling in an oblique direction and is extracted out of the sealing lens, it is preferable that the ceiling surface 10a be an optically flat plane. It should be noted that the slope does not need to be flat when viewed in cross-section and may be curved when viewed in cross-section.

As mentioned earlier, it is desirable that the vertex 10c of the mortar shape be as close as possible to the substrate to such an extent so not to make contact with the wavelength conversion section 40. At the same time, it is desirable that the angle of inclination θ of the mortar-shaped slope 10b range from an angle approximately equal to the critical angle θc of total reflection to 60 degrees. In view of both of these in combination, an upper limit to the desirable height (H in (e) of Fig. 2) of the sealing lens 10 determines itself with respect to the width W of the sealing lens 10.

In a case where the mortar-shaped slope 10b is made as wide as possible, its depth (H0 in (e) of Fig. 2) is approximately 0.45 to 0.86 times as great as the width (W in (e) of Fig. 2) of the sealing lens 10. According to (e) of Fig. 2, H0 is determined by W·tanθ/2. It should be noted here that H0/W was calculated based on the fact that a desirable value of θ ranges from the critical angle θc (which is 41.8 degrees when *n* = 1.5) to 60 degrees. Therefore, the upper limit to the desirable height (H in (e) of Fig. 2) of the sealing lens 10 can be said to be a height (H0 in (e) of Fig. 2) calculated from the value of H0/W in view of the distance between the substrate 20 and the vertex 10c of the mortar shape in a case where the vertex 10c is located as close as possible to the substrate to such an extent as not to make contact with the wavelength conversion section 40.

More specifically, an example of the typical dimensions of the mortar-shaped light-emitting device 50 as described above where the sealing lens 10 is 2.8 mm (which corresponds to W in (e) of Fig. 2) is now discussed. A typical case is discussed where the thickness of the wavelength conversion section 40, which covers the LED chips 25, along a direction perpendicular to the substrate is 0.3 mm (h1 in (e) of Fig. 2) and the distance (h2 in (e) of Fig. 2) from the wavelength conversion section 40 to the vertex 10c is 0.1 mm. In this case, the distance H1 between the substrate 20 and the vertex 10c is 0.4 mm, which is 0.14 times as great as the width of 2.8 mm of the sealing lens 10. Therefore, in this typical example, the upper limit to the desirable height (H in (e) of Fig. 2) of the sealing lens 10 can be said to range roughly from 0.6 to 1.1 times as great as the width of the sealing lens 10.

### (Planar Light Source)

Fig. 10 shows a schematic diagram of a planar light source (planar light source device) 100 according to Embodiment 1, the illumination profile of each mortar-shaped light-emitting device 50, and a pattern of arrangement of mortar-shaped light-emitting devices 50. (a) of Fig. 10 is a side view of a display device 100 including a planar light source 100 and a liquid crystal panel 150. As shown in (a) of Fig. 10, the planar light source 100 includes a mounting substrate 110, a plurality of mortar-shaped light-emitting devices 50 disposed on the mounting substrate 110, and a group of optical sheets 113 put on top of one another in parallel with a surface of the mounting substrate 110 to face the mounting substrate 110. That one of the group of optical sheets 113 which is closest to the mortar-shaped light-emitting devices 5 has a surface facing the mortar-shaped light-emitting devices 5, and the distance between this surface and the surface of the mounting substrate 110 is d. Light emitted from the mortar-shaped light-emitting devices 50 illuminates the back surface of the group of optical sheets 113, is uniformly distributed by the group of optical sheets 113, is focused toward the front surface within a predetermined angle, and is emitted in the form of planar light through the front surface. It should be noted that the liquid crystal panel 150 is configured to be able to be driven for each separate region including a plurality of pixels, and that the planar light source 100 is configured such that its luminance can be adjusted for each separate region including the plurality of pixels.

Each of the mortar-shaped light-emitting devices 50 has its maximum angle of radiation α1 or α2 in an oblique direction in terms of a distribution of angles of radiation, but since such an oblique direction is distant from the light source, the mortar-shaped light-emitting device 50 still has its maximum luminance directly above the light source in terms of a distribution of illumination. As will be mentioned later, the optical sheets serve to reduce luminance by directing light back to the light source directly above the light source, increase luminance by directing light upward when the light is away from the light source, and thereby achieve a uniform distribution of light.

For a higher reflectance, the mounting substrate has its surface painted in white or mounted with a reflecting sheet (not illustrated) provided with a hole through which a mounting part of the mortar-shaped light-emitting device 50 passes.
(b) of Fig. 10 is a schematic diagram showing correspondence between a mortar-shaped light-emitting device 50 and its illumination profile. The sealing lens 10 of the mortar-shaped light-emitting device 50 has a mortar-shaped slope 10b in its central part when viewed planimetrically, and the illumination profile 58 on a surface of that one of the group of optical sheets 113 which is closest to the mortar-shaped light-emitting device 50 opposite the liquid crystal panel is a substantially rectangular shape having its vertices diagonally across the sealing lens 10.
(c) of Fig. 10 is a plan view showing an arrangement of mortar-shaped light-emitting devices 50 and the illumination profiles of them as a planar light source. On the mounting substrate 110, as shown in (c) of Fig. 10, mortar-shaped light-emitting devices 50 each having such an illumination profile as shown in (b) of Fig. 10 are squarely arrayed so that the rectangular illumination profile has one end substantially parallel to either of the array directions. That is, as indicated by chain double-dashed lines in (c) of Fig. 10, lattice points at which one array axis 114 intersects with another form vertices of squares, and the mortar-shaped light-emitting devices 50 are arrayed so as to be located on the respective lattice points. Further, the mortar-shaped light-emitting devices 50 are arrayed at pitches of Px (=P) along the x direction and at pitches of Py (=P) along the y direction. Such a simple square arrangement of mortar-shaped light-emitting devices 50 each having a rectangular illumination profile makes it easy to obtain a planar light source that is high in in-plane uniformity of illuminance.

In (c) of Fig. 10, the diagonal direction B across the substantially rectangular illumination pattern (illumination profile) coincides with (i.e., is parallel to) a diagonal direction C across the square arrangement of mortar-shaped light-emitting devices 50.

Furthermore, for minimization of an overlap between the illumination patterns of adjacent mortar-shaped light-emitting devices 50, (i) the pitches P at which the mortar-shaped light-emitting devices 50 are arrayed and (ii) the distance d between the surface, which faces the mortar-shaped light-emitting devices 50, of the optical sheet which is closest to the mortar-shaped light-emitting devices 50 and the surface of the mounting substrate on which the mortar-shaped light-emitting devices 50 are placed are appropriately set ((a) of Fig. 10).

That is, the mortar-shaped light-emitting devices 50 are arranged, without rotating the main axis 11 of Fig. 2, so that as viewed from above, the quadrangular shape of each of the sealing lens 10 has one side parallel to either of the array directions.

With this arrangement, the rectangular illumination patterns of mortar-shaped light-emitting devices 50 adjacent to each other along the diagonal direction across the square arrangement of mortar-shaped light-emitting devices 50 can fill a gap in the surface, so luminance unevenness can be reduced. In such a rectangular illumination pattern, when three-dimensionally viewed as the light-distribution characteristics of the mortar-shaped light-emitting devices 50 as shown in (f) of Fig. 10, the following relationship holds: α1 < α2, where α1 is the angle formed by the direction of emission of light at the maximum intensity and the main axis in a plane containing either of the array directions (i.e., either of the x and y directions) of the mortar-shaped light-emitting devices 50 and the main axis 11 of each of the mortar-shaped light-emitting devices 50, and α2 is the angle formed by the direction of emission of light at the maximum intensity and the main axis in a plane containing the diagonal direction across the array of mortar-shaped light-emitting devices 50 and the main axis of each of the mortar-shaped light-emitting devices 50.

In this case, it is necessary that the illumination profile is more protruding along the diagonal direction across the light source array than along the array directions (i.e., the x and y directions). By satisfying this condition, a gap in the light source array along the diagonal direction can be filled, so luminance unevenness along the diagonal direction can be reduced.

As an example of the present embodiment, each of the pitches Px and Py of the square arrangement was 45 mm, and the distance d between the surface of the mounting substrate 110 and that surface of the optical sheet closest to the mortar-shaped light-emitting devices 50 which faces the mortar-shaped light-emitting devices 50 was 22 mm. Light emitted from the mortar-shaped light-emitting devices 50 is emitted in such a way as shown in (a) of Fig. 6 to have a peak sticking out along the main axis 11. At the same time, the direction of emission of light of maximum intensity is distributed in such a way that the light of maximum intensity is emitted in a direction inclined at 45 degrees to the main axis 11 to surround the main axis 11.

With such a distribution of the direction of emission of light, the mortar-shaped light-emitting devices 50 not only illuminate those positions on the group of optical sheets 113 which are directly above the mortar-shaped light-emitting devices 50, but also illuminate those positions on the group of optical sheets 113 which are above spaces between the mortar-shaped light-emitting devices 50. This contributes to an improvement in luminance unevenness in those positions on the group of optical sheets 113 which are above spaces between the mortar-shaped light-emitting devices 50. The angle of the direction of emission of light of maximum intensity with respect to the main axis 11 can be changed by adjusting the shape of each of the sealing lens 10. For reduction in luminance unevenness and color unevenness, it is desirable that the angle be 30 to 50 degrees, as long as the angle is in the after-mentioned range of relationship with the pitches Px and Py and the distance d.

Specific examples of the optical sheets put on top of one another includes first and second unevenness eliminating sheets 113a and 113b put on top of each other. The first unevenness eliminating sheet 113a is located closer to the mortar-shaped light-emitting devices 50 than the second unevenness eliminating sheet 113b is.

As shown in (d) of Fig. 10, the first unevenness eliminating sheet 113a and the second unevenness eliminating sheet 113b are each an optical sheet composed of a translucent member whose surface has a lenticular structure. The luminance and color unevenness of light entering the optical sheet are corrected along the direction along which convex shapes are arrayed. It should be noted that the pitches at which the convex shapes are arrayed are smaller than the pitches at which the mortar-shaped light-emitting devices 50 are arrayed.

The term "lenticular structure" above means a surface shape, such as the one disclosed in Japanese Patent Application Publication, Tokukaihei, No. 6-194651 A (1994), which has a plurality of partially (semi)circular long convex shapes, arrayed in parallel at pitches P', each of which has a cross-section containing part of an ellipse or a circle. The focusing and dispersion characteristics of the lenticular structure are adjusted in accordance with the light-distribution characteristics of the planar light source according to the present embodiment, and the dimensions are not necessarily the same as those disclosed in Japanese Patent Application Publication, Tokukaihei, No. 6-194651 A (1994).

The reason why the convex shapes are arrayed at smaller pitches than the mortar-shaped light-emitting devices 50 is explained here with reference to Fig. 11.

Fig. 11 shows cases of optical sheets 1124 each having a lenticular structure (lenticular lens structure), (a) and (c) each being a front view showing an arrangement of a point light source 1121 and the optical sheet 1122 and the direction of emission of light, (b) and (d) each being a plan view showing a pattern of emission as seen from above the optical sheet 1122.

The optical sheet 1124 is either a first or second unevenness eliminating sheet 113a or 113b. Further, as shown in (d) of Fig. 11, the optical sheet 1124 has a lenticular structure whose surface shape has a plurality of partially (semi)circular long convex shapes, arrayed in parallel at pitches P', each of which has a cross-section containing part of an ellipse or a circle. Furthermore, the optical sheet 1124 has a bottom surface 1125 as shown in (a) and (c) of Fig. 11. Fig. 11 takes into consideration the refraction of light on the bottom surface 1125.

First, as shown in (a) and (c) of Fig. 11, light entering the lenticular structure of the optical sheet 1124 at a critical angle βc or smaller is reflected inward without being extracted upward (see the shaded areas 201 (dark areas) in the drawings. As indicted by a dotted arrow, light entering such an area is reflected by a concavely curved surface and also reflected by an opposite curved surface to travel downward). Light entering at an angle larger than the critical angle βc is extracted upward (see the areas 202 (bright areas) in the drawings. Light entering such a region is refracted to be extracted upward).

Further, as shown in (a) and (b) of Fig. 11, in a case where the width of each separate bright or dark area is greater and the density of the bright and dart areas are lower, luminance unevenness is more conspicuous.

On the other hand, as shown in (c) and (d) of Fig. 11, in a case where the width of each separate bright or dark area is smaller and the density of the bright and dart areas are higher, luminance unevenness becomes less conspicuous.

For such a reason, the convex shapes of the first and second unevenness eliminating sheets 112a and 112b arrayed at the pitches P' that are smaller than the pitches Px and Py at which the mortar-shaped light-emitting devices 50 are arrayed.

It should be noted that in such a position that is above a space between one point light source (LED light source, which is a mortar-shaped light-emitting device 50 in this example) 1121 and another, not in a position that is directly above a point light source 1121, the angle of incidence is more oblique so that light is likely to enter at an angle larger than the angle of total reflectance (critical angle βc). Therefore, the dark areas tend to become smaller in width.

The foregoing unevenness eliminating sheets are just an example of unevenness eliminating sheets. As long as the desired focusing and dispersion characteristics are obtained for elimination of luminance unevenness, the lenticular structure may have long convex shapes each having a triangular cross-section.

The first unevenness eliminating sheet 113a is placed so that the longitudinal direction (referred to also as "busbar direction") of the convex shapes of the first unevenness eliminating sheet 113a and the direction of one side of the substantially rectangular illumination profile of each of the mortar-shaped light-emitting devices 50 are parallel to each other, whereby luminance unevenness and color unevenness along the X direction are uniformized. In practice, the first unevenness eliminating sheet 113a is placed so that the longitudinal direction of the convex shapes of the first unevenness eliminating sheet 113a and one side of the rectangular contour of the sealing resin of each of the mortar-shaped light-emitting devices 50 as seen from above are parallel to each other. Alternatively, the first unevenness eliminating sheet 113a is placed so that the longitudinal direction of the convex shapes of the first unevenness eliminating sheet 113a and one side of the rectangular contour of the mounting substrate 110 when the mortar-shaped light-emitting devices 50 are seen from above are parallel to each other. Alternatively, the first unevenness eliminating sheet 113a is placed so that the longitudinal direction of the convex shapes of the first unevenness eliminating sheet 113a and the X direction along which the mortar-shaped light-emitting devices 50 are arrayed are parallel to each other. In other words, as shown in (e) of Fig. 10, the first unevenness eliminating sheet 113a is placed so that the busbar direction D of the lens structure of the first unevenness eliminating sheet 113a and the direction E of one side of the illumination profile (contour of the sealing resin of the package (whose peripheral border is rectangular as seen from above)) are placed substantially in parallel with each other.

The second unevenness eliminating sheet 113b is placed on the first unevenness eliminating sheet 113a so that the longitudinal direction of the convex shapes of the second unevenness eliminating sheet 113b is substantially perpendicular to the longitudinal direction of the convex shapes of the first unevenness eliminating sheet 113a. That is, the second unevenness eliminating sheet 113b is placed so that the longitudinal direction of the convex shapes of the second unevenness eliminating sheet 113b is parallel to the direction of another side of the substantially rectangular illumination profile of each of the mortar-shaped light-emitting devices 50 that is substantially perpendicular to the one side mentioned above, whereby luminance unevenness and color unevenness along the Y direction are uniformized.

It should be noted that luminance unevenness and color unevenness along a diagonal direction across each substantially rectangular illumination profile is uniformized by appropriately adjusting the intervals at which the mortar-shaped light-emitting devices 50 are arrayed, in addition to using the two unevenness eliminating sheets as described above. This causes the luminance unevenness and the color unevenness to be better uniformized by a combined effect of overlapping of rectangular illumination patterns of mortar-shaped light-emitting devices 50 adjacent to one another along the X direction, the Y direction, and the diagonal direction.

It should be noted that in order to eliminate persistent luminance and color unevenness, it is possible to further put unevenness eliminating sheets of the X and Y directions on each of the unevenness eliminating sheets. Further, in order to save on one unevenness eliminating sheet, the intervals at which the mortar-shaped light-emitting devices 50 are arrayed along the X or Y direction may be narrowed (the square arrangement may be changed to a rectangular arrangement) so that the unevenness is eliminated by increasing overlapping of the illumination profiles of mortar-shaped light-emitting devices 50 adjacent to one another along either of the directions. This makes it only necessary to provide an unevenness eliminating sheet of the other direction.

Further, in order to guide light upward, it is possible to provide luminance improving films 113c and 113d between the unevenness eliminating sheets and the liquid crystal panel. The luminance improving films 113c and 113d, which are commonly known, are optical sheets that have convex shapes similar to those of the aforementioned unevenness eliminating sheets but differ more or less in shape from the aforementioned unevenness eliminating sheets. For example, the convex shapes of the luminance improving films 113c and 113d are arrayed at intervals different from those at which the concaves shapes of the aforementioned unevenness eliminating sheets are arrayed, or the convex shapes of the luminance improving sheets 113c and 113d each have a cross-section configured to have a plurality of triangles overlapped with each other. Further, the luminance improving films have a focusing function by which light entering the luminance improving films through their lower surfaces is extracted as upward light within a predetermined angle. Light other than the light extracted upward is returned toward the housing by reflection, reflected by the housing, allowed to reenter the luminance improving films 113c and 113d, and recycled to be extracted upward, thus increasing frontal luminance. The luminance improving films have an effect of reducing luminance unevenness along a direction perpendicular to the longitudinal direction of the convex shapes, although not comparable to the unevenness eliminating films. As such, luminance improving films may be used to replace the unevenness eliminating sheet (i.e., the two films for use in elimination of unevenness along the X and Y directions) to be put on top of the second unevenness eliminating sheet.

It should be noted that in consideration of the unevenness eliminating effect, the aforementioned pitches Px and Py and distance d are adjusted to satisfy d / P < 0.7, where P denotes the pitches Px and Py.

When the distance d is set large or the pitches P are set small so that d/P ≥ 0.7, an increase in overlapping of the illumination profiles of adjacent light-emitting devices leads to an increase in luminance in a space between the light-emitting devices, thus making luminance unevenness likely to occur. Further, as for the pitches P, it is preferable that P ≥ 15 mm. There are two reasons for this. One of the reasons is that in a case where the pitches P are too small, there occurs too much interference between the illumination profiles of adjacent light-emitting devices, with the result that the unevenness eliminating sheets no longer exert their effects. The other reason is that the number of light-emitting devices should be reduced from a cost standpoint.

Further, in a case where the mortar-shaped light-emitting devices 50 are arranged in the form of an oblong shape, e.g., so that the pitches Py along the y direction are smaller than the pitches Px along the x direction, it is preferable, for the same reasons as those stated above, that the pitches Px and Py and the distance d be adjusted to satisfy Px ≥ 15 mm and d/Px < 0.7.

It should be noted that the mortar-shaped light-emitting devices 50 may be replaced by light-emitting devices of another sealing resin configuration as shown in embodiments other than the present embodiment, as long as the latter light-emitting devices each have a substantially rectangular illumination profile.

Further, the substantially rectangular illumination profile may have its corners slightly protruding diagonally, albeit not as protruding diagonally as in the X-shaped illumination profile of the cloverleaf light-emitting device 70 shown in (c) of Fig. 7.

Further, since each of the mortar-shaped light-emitting devices 50 illuminates a wider area than does any one of the domed light-emitting devices 60, the number of light-emitting devices can be reduced when a planar light source is constituted by a plurality of mortar-shaped light-emitting devices 50. Further, since each of the mortar-shaped light-emitting devices 50 emits light at a high angle of emission, i.e., emits light nearly in a direction parallel to the mounting substrate 110, the distance from the mounting substrate 110 to the group of optical sheets 113 can be made smaller, which gives an advantage in terms of reduction in thickness of the backlight.

Further, the mortar-shaped light-emitting devices 50 are much simpler than the cloverleaf light-emitting devices 70 in that the mortar-shaped light-emitting devices 50 each have a substantially rectangular illumination profile. For this reason, unlike the cloverleaf light-emitting devices 70, the mortar-shaped light-emitting devices 50 do not need to be specially arranged in consideration of overlap between bright and dark portions of the illumination profiles for in-plane uniformity of illuminance.
That is, the mortar-shaped light-emitting devices 50 do not need to be placed with their main axes rotated in accordance with the illumination profiles, nor do they need to be arranged in a houndstooth pattern. This makes it possible to greatly simplify the design and production of a planar light source. Furthermore, this makes it possible to greatly simplify the design and production of a backlight to be provided in an area active (local dimming) display device to be described later.

It should be noted that although the term "rectangular shape" in the present embodiment refers to a square or an oblong shape, but its contour, including the vertices, may be rounded and curved. The term "curve" encompasses a mixture of slightly concave and convex curves smoothly combined, as seen from outside of the rectangular shape.

### (Embodiment 2)

Another embodiment of the present invention is described below with reference to Figs. 12 through 15. It should be noted that the present embodiment is identical in configuration to Embodiment 1 except for that which is described in the present embodiment. Further, for convenience of explanation, members having the same functions as those shown in the drawings of Embodiment 1 are given the same reference numerals and, as such, are not described below.

Fig. 12 shows a plan view, a front view, and a side view of a wedge-shaped light-emitting device 80 according to Embodiment 2, and Fig. 13 shows an internal structure thereof. Fig. 14 shows the light-distribution characteristic and illumination profile of the wedge-shaped light-emitting device 80 of Embodiment 2. The wedge-shaped light-emitting device 80 of Embodiment 2 is described with emphasis on the difference between the wedge-shaped light-emitting device 80 of Embodiment 2 and a mortar-shaped light-emitting device 50 of Embodiment 1.

Fig. 12 shows explanatory diagrams explaining the wedge-shaped light-emitting device 80 according to Embodiment 2. (a) of Fig. 12 is a plan view of the wedge-shaped light-emitting device 80 according to Embodiment 2. (b) of Fig. 12 is a front view of the wedge-shaped light-emitting device 80 according to Embodiment 2. (c) of Fig. 12 is a side view of the wedge-shaped light-emitting device 80 according to Embodiment 2.

Fig. 13 shows explanatory diagrams explaining the wedge-shaped light-emitting device 80 according to Embodiment 2. (a) of Fig. 13 is a plan view showing an internal structure of the wedge-shaped light-emitting device 80 according to Embodiment 2. (b) of Fig. 13 is a front view showing the internal structure of the wedge-shaped light-emitting device 80 according Embodiment 2. (c) of Fig. 13 is a side view of the wedge-shaped light-emitting device 80 according to Embodiment 2. (d) of Fig. 13 is an enlarged view of long LED chips 65 and an area therearound in the wedge-shaped light-emitting device 80 according to Embodiment 2. (e) of Fig. 13 is a plan view showing one long LED chip 65 being die-bonded to a position directly below the vertex 10c of the letter V in the wedge-shaped light-emitting device 80 according to Embodiment 2.

The wedge-shaped light-emitting device 80 has such features in appearance that the sealing lens 10 has a quadrangular shape when viewed planimetrically and has a concavely sunken part located above a substantially central part of the substrate 20. The concavely sunken part has a V-shaped cross-section (see the front view). Further, when viewed in cross-section orthogonal to the V-shaped cross-section (see the side view), the concavely sunken part has a concave shape with a flat bottom. As a whole, the concavely sunken part forms a wedge-shaped groove.

It should be noted here that, as shown in (a) of Fig. 13, a total of four LED chips 65 are die-bonded symmetrically about the bottom of the letter V so that their longer sides are parallel to the V-shaped groove. That is, the LED chips 65 are arranged so that the bottom of the letter V extends directly above the center of a space area between two of the LED chips 65 and the other two LED chips 65.

Such a configuration allows the position of the vertex 10c of the letter V as viewed planimetrically in (d) of Fig. 13 to fall within the space area 12b among the LED chips as shown in (d) of Fig. 13 so that the four long LED chips 65 are arranged substantially evenly on either side with respect to the wedge-shaped slope 10b and the vertex 10c, even if the die-bonding position is slightly displaced along the x direction or the y direction or, even if, in the case of molding of the sealing lens 10, the position of the vertex 10c of the wedge-shaped slope 10b is slightly displaced along the x direction or the y direction. For this reason, the resulting light-distribution characteristics of the wedge-shaped light-emitting device 80 is stably high in symmetry.

The description here is given with reference to the four long LED chips 65. However, the shape of each chip is not limited to such a long shape. Further, it is possible to arrange a total of two LED chips with one of them on the right side of the letter V and the other on the left side, or arrange a total of six LED chips with three of them on the right side of the letter V and the other three on the left side. In short, it is only necessary to arrange LED chips in consideration of symmetry about the wedge groove.

It should be noted that the wedge-shaped light-emitting device 80 may also be configured such that, as shown in (e) of Fig. 13, a single LED chip 25, or a plurality of chips, is die-boned to a position directly below the vertex 10c of the letter V. In this case, it is essential to distribute light evenly on either side by strictly managing manufacturing so that the center of the LED chip 25 is located directly below the vertex 10c of the letter V. For this reason, the degree of difficulty with which products of the same light-distribution characteristics are stably produced is higher than in the case where the four long LED chips 65 are disposed evenly as shown in (a) of Fig. 13.

Further, due to problems of processing accuracy, it is difficult to make the vertex 10c of the letter V in the form of an ideal vertex, and the placement of an LED chip 25 as shown in (e) of Fig. 13 causes a problem of leakage of light upward along the axis. For this reason, it is especially preferable, for realization of stable characteristics in production, that the mortar-shaped light-emitting device 50 be structured such that such LED chips 25 as those shown in (a) of Fig. 13 are arrayed in a position displaced from the vertex 10c.

Fig. 14 shows the light-distribution characteristics and illumination profile of the wedge-shaped light-emitting device of Embodiment 2. (a) of Fig. 14 is a simulation diagram three-dimensionally showing the light-distribution characteristics of the wedge-shaped light-emitting device 80 according to Embodiment 2, and the intensity of emitted light is indicated by the distance from the center 11a to an outer edge surface 56. (b) of Fig. 14 is a simulation diagram showing the illumination profile of the wedge-shaped light-emitting device 80 according to Embodiment 2.

The term "illumination profile" here means an illumination profile obtained by illuminating a diffusing plate 112, and in (b) of Fig. 14, the chain double-dashed line indicates a contour line 58. As shown in (b) of Fig. 14, the illumination profile of the wedge-shaped light-emitting device 80 forms a substantially rectangular and substantially oblong illumination profile on the diffusing plate 112.

It should be noted that it is desirable, for the same reasons as those stated in Embodiment 1, that the angle of inclination θ of the wedge-shaped slope 10b range from an angle approximately equal to the critical angle θc of total reflection to 60 degrees.

### (Planar Light Source)

Fig. 15 shows a schematic diagram of a planar light source 200 of Embodiment 2 and a pattern of arrangement of wedge-shaped light-emitting devices. (a) of Fig. 15 is a side view of a display device including a planar light source 200, a group of optical sheets 113 put on top of one another, and a liquid crystal panel 150. (b) of Fig. 15 is a schematic diagram showing correspondence between a wedge-shaped light-emitting device 80 and its illumination profile. (c) of Fig. 15 is a plan view showing an arrangement of wedge-shaped light-emitting devices 80 and the illumination profiles of them as a planar light source.

The mortar-shaped light-emitting device 50, as shown (b) of Fig. 6, has a substantially rectangular and substantially square illumination profile. Such a simple square arrangement of mortar-shaped light-emitting devices 50 in a pattern of arrangement in a planar light source 100 as shown in (c) of Fig. 10 makes it easy to obtain a planar light source that is high in in-plane uniformity of illuminance.

It should be noted that although the term "substantially rectangular (rectangular shape)" encompasses a figure whose contour, including the vertices, is rounded and curved. The term "curve" encompasses a shape having a mixture of slightly outward concave and convex curves smoothly combined, as seen from outside of the rectangular shape.

On the other hand, the wedge-shaped light-emitting device 80, as shown (b) of Fig. 14, has a substantially rectangular but substantially oblong illumination profile. This makes it necessary to change the pattern of arrangement of wedge-shaped light-emitting devices 80 as shown in (c) of Fig. 15. Such a simple oblong arrangement of mortar-shaped light-emitting devices 50 in accordance with the illumination profile makes it easy to obtain a planar light source that is high in in-plane uniformity of illuminance.

The group of optical sheets 113 includes first and second unevenness eliminating sheets 113a and 113b put on top of each other.

As shown in (d) of Fig. 15, the first unevenness eliminating sheet 113a and the second unevenness eliminating sheet 113b are each a translucent optical sheet having the same structure as that shown in Embodiment 1. The luminance and color unevenness of light entering the optical sheet are corrected along the direction along which convex shapes are arrayed.

The first unevenness eliminating sheet 113a is placed so that the longitudinal direction (referred to also as "busbar direction") of the convex shapes of the first unevenness eliminating sheet 113a and the direction of one side of the substantially rectangular illumination profile of each of the wedge-shaped light-emitting devices 80 are parallel to each other, whereby luminance unevenness and color unevenness along the X direction are uniformized. In practice, the first unevenness eliminating sheet 113a is placed so that the longitudinal direction of the convex shapes of the first unevenness eliminating sheet 113a and one side of the rectangular contour of the sealing resin of each of the wedge-shaped light-emitting devices 80 as seen from above are parallel to each other. Alternatively, the first unevenness eliminating sheet 113a is placed so that the longitudinal direction of the convex shapes of the first unevenness eliminating sheet 113a and one side of the rectangular contour of the mounting substrate 110 when the wedge-shaped light-emitting devices 80 are seen from above are parallel to each other. Alternatively, the first unevenness eliminating sheet 113a is placed so that the longitudinal direction of the convex shapes of the first unevenness eliminating sheet 113a and the X direction along which the wedge-shaped light-emitting devices 80 are arrayed are parallel to each other.

The second unevenness eliminating sheet 113b is placed on the first unevenness eliminating sheet 113a so that the longitudinal direction of the convex shapes of the second unevenness eliminating sheet 113b is substantially perpendicular to the longitudinal direction of the convex shapes of the first unevenness eliminating sheet 113a. That is, the second unevenness eliminating sheet 113b is placed so that the longitudinal direction of the convex shapes of the second unevenness eliminating sheet 113b is parallel to the direction of another side of the substantially rectangular illumination profile of each of the wedge-shaped light-emitting devices 80 that is substantially perpendicular to the above one side, whereby luminance unevenness and color unevenness along the Y direction are uniformized.

It should be noted that luminance unevenness and color unevenness along a diagonal direction across each substantially rectangular illumination profile is uniformized by appropriately adjusting the intervals at which the wedge-shaped light-emitting devices 80 are arrayed, in addition to using the two unevenness eliminating sheets as described above. This causes the luminance unevenness and the color unevenness to be better uniformized by a combined effect of overlapping of rectangular illumination patterns of wedge-shaped light-emitting devices 80 adjacent to one another along the X direction, the Y direction, and the diagonal direction.

Further, in order to guide light upward, it is possible to provide luminance improving films 113c and 113d between the unevenness eliminating sheets and the liquid crystal panel as mentioned above in Embodiment 1.

Furthermore, it is possible to add a diffusing material to each of the unevenness eliminating sheets.

It should be noted that the wedge-shaped light-emitting devices 80 may be replaced by light-emitting devices shown in embodiments other than the present embodiment and each having a substantially rectangular pattern of light emission. In such a case, the intervals at which the light-emitting devices are arrayed are adjusted as needed.

Further, the substantially rectangular illumination profile may have its corners slightly protruding diagonally, albeit not as protruding diagonally as in the X-shaped illumination profile of the cloverleaf light-emitting device 70 shown in (c) of Fig. 7. Alternatively, the substantially rectangular illumination profile may be wholly rounded.

Each of the wedge-shaped light-emitting devices 80 of the present embodiment may be configured such that the sunken part is a wedge-shaped groove having its vertex facing the substrate and that the groove has a V-shaped transverse cross-section.

Further, the wedge-shaped light-emitting device 80 may include a plurality of long LED chips 65, and the plurality of long LED chips 65 may be arranged around a plane which is a symmetry plane of the wedge shape and which extends through the bottom of the letter V.

Furthermore, the wedge-shaped light-emitting device 80 may include two long LED chips 65 or a 2 multiple of long LED chips 65, and the two long LED chips 65 or the 2 multiple of long LED chips 65 may be arranged symmetrically at a distance from each other around a symmetry plane of the wedge shape.

### (Embodiment 3)

Another embodiment of the present invention is described below with reference to Figs. 16 and 17. It should be noted that the present embodiment is identical in configuration to Embodiments 1 and 2 except for that which is described in the present embodiment. Further, for convenience of explanation, members having the same functions as those shown in the drawings of Embodiment 1 and 2 are given the same reference numerals and, as such, are not described below.

Fig. 16 shows explanatory diagrams explaining a light-emitting device 90 in Embodiment 3 or, more specifically, a plan view and a front view of the light-emitting device 90 in Embodiment 3. Fig. 17 shows the light-distribution characteristic and illumination profile of the light-emitting device 90 in Embodiment 3.
(a) of Fig. 16 is a plan view of the light-emitting device 90 according to Embodiment 3. (b) of Fig. 16 is a front view of the light-emitting device 90 according to Embodiment 3. (c) of Fig. 16 is an enlarged view of LED chips 25 and an area therearound in the light-emitting device 90 according to Embodiment 3. (d) of Fig. 16 is a plan view showing one LED chip being die-bonded to a position directly below the vertex of the letter V in the light-emitting device 90 according to Embodiment 3.

The difference in appearance between the light-emitting device 90 and the wedge-shaped light-emitting device 80 of Embodiment 2 lies in the shape of the concavely sunken part located in the central part of the sealing lens 10. That is, the concavely sunken part of Embodiment 3 is shaped as if concavely sunken parts of Embodiment 2 intersected crosswise with each other.

It should be noted here that, as shown in (a) of Fig. 16, a total of four LED chips 25 are die-bonded symmetrically about the bottom of the letter V. Further, the LED chips 25 are arranged so that the bottom of the cross extends directly above the centers of the space areas 12a and 12b among the LED chips 25.

Such a configuration allows the position of the vertex 10c of the letter V as viewed planimetrically in (c) of Fig. 16 to fall within the space areas 12a and 12b among the LED chips as shown in (c) of Fig. 16 so that the four long LED chips 25 are arranged substantially evenly on either side with respect to the wedge-shaped slope 10b and the vertex 10c, even if the die-bonding position is slightly displaced along the x direction or the y direction or, even if, in the case of molding of the sealing lens 10, the position of the vertex 10c of the wedge-shaped slope 10b is slightly displaced along the x direction or the y direction. For this reason, the resulting light-distribution characteristics of the wedge-shaped light-emitting device 90 is stably high in symmetry.

It should be noted that the light-emitting device 90 may also be configured such that, as shown in (d) of Fig. 16, a single LED chip 25 is die-bonded to a central part of the cross or a plurality of chips are die-boned to a position directly below the vertex 10c of the letter V. In this case, it is essential to distribute light evenly on either side by strictly managing manufacturing so that the center of the LED chip 25 is located directly below the vertex 10c of the letter V. For this reason, the degree of difficulty with which products of the same light-distribution characteristics are stably produced is higher than in the case where the four long LED chips 25 are disposed evenly as shown in (a) of Fig. 16.

Further, due to problems of processing accuracy, it is especially preferable, for realization of stable characteristics in production, that the light-emitting device 90 be structured such that such LED chips 25 as those shown in (a) of Fig. 16 are arrayed in a position displaced from the vertex 10c.

It should be noted that it is desirable, for the same reasons as those stated in Embodiment 2, that the angle of inclination θ of the wedge-shaped slope 10b range from an angle approximately equal to the critical angle θc of total reflection to 60 degrees.

Fig. 17 shows the illumination profile of the light-emitting device 90 according to Embodiment 3. (a) of Fig. 17 is a simulation diagram three-dimensionally showing the light-distribution characteristics of the light-emitting device 90 according to Embodiment 3. (b) of Fig. 17 is a simulation diagram showing the illumination profile of the light-emitting device 90 according to Embodiment 3.

The light-emitting device 90, as shown (b) of Fig. 17, has a substantially rectangular and substantially square illumination profile on the diffusing plate 112. For this reason, as in the case of mortar-shaped light-emitting devices 50, each of which forms a similar illumination profile, a square arrangement of light-emitting devices 90 makes it easy to obtain a planar light source that is high in in-plane uniformity of illuminance. It should be noted that although the term "substantially rectangular (rectangular shape)" encompasses a figure whose contour, including the vertices, is rounded and curved. The term "curve" encompasses a shape having a mixture of slightly outward concave and convex curves smoothly combined, as seen from outside of the rectangular shape.

In the light-emitting device 90 according to the present embodiment, the sunken parts each have its vertex pointing to the substrate, and are each in the form of two wedge-shaped grooves intersecting with each other and each having a V-shaped cross-section.

Further, the light-emitting device 90 may include a plurality of LED chips 25 arranged symmetrically about a symmetry plane of each of the wedge shapes.

Furthermore, the light-emitting device 90 may include four LED chips 25 die-bonded at spaces coinciding with the vertices of the V-shaped grooves as seen from the top surface 10a.

### (Embodiment 4)

Another embodiment of the present invention is described below with reference to Figs. 18 and 19. It should be noted that the present embodiment is identical in configuration to Embodiments 1 to 3 except for that which is described in the present embodiment. Further, for convenience of explanation, members having the same functions as those shown in the drawings of Embodiments 1 to 3 are given the same reference numerals and, as such, are not described below.

Fig. 18 shows explanatory diagrams explaining a light-emitting device 190 according to Embodiment 4. (a) of Fig. 18 is a plan view of the light-emitting device 190 according to Embodiment 4. (b) of Fig. 18 is a front view of the light-emitting device 190 according to Embodiment 4. (c) of Fig. 18 is a side view of the light-emitting device 190 according to Embodiment 4. (d) of Fig. 18 is a side view of the light-emitting device 190 according to Embodiment 190 as seen from an oblique angle of 45 degrees (from an angle θa).

Fig. 19 shows the light-distribution characteristics and illumination profile of the light-emitting device 190 according to Embodiment 4. (a) of Fig. 19 is a simulation diagram three-dimensionally showing the light-distribution characteristics of the light-emitting device 190 according to Embodiment 4. (b) of Fig. 19 is a simulation diagram showing the illumination profile of the light-emitting device 190 according to Embodiment 4.

The light-emitting device 190 is different in appearance from the light-emitting device 90 of Embodiment 3 in that, as shown in Fig. 18, crossed V-shaped grooves formed in the sealing lens 10 each extend along a diagonal direction from one vertex to the other.

Even such a shape makes it possible to form a substantially rectangular and substantially square illumination profile on the diffusing plate 112 as shown in Fig. 19. For this reason, as in the case of mortar-shaped light-emitting devices 50, each of which forms a similar illumination profile, a square arrangement of light-emitting devices 190 makes it easy to obtain a planar light source that is high in in-plane uniformity of illuminance. It should be noted that although the term "substantially rectangular (rectangular shape)" encompasses a figure whose contour, including the vertices, is rounded and curved. The term "curve" encompasses a shape having a mixture of slightly outward concave and convex curves smoothly combined, as seen from outside of the rectangular shape.

The light-emitting device 190 according to the present embodiment is a light-emitting device including a substrate 20, LED chips 25 die-bonded to the substrate 20, and a wavelength conversion section 40 covering the LED chips 25. The wavelength conversion section 40 includes surfaces composed of four planes standing upright with respect to the substrate 20. The four planes are on all four sides to surround the wavelength conversion section 40. The wavelength conversion section 40 has a ceiling side right opposite the substrate 20. On the ceiling side, two wedge-shaped grooves each having its vertex pointing to the substrate 20 intersect with each other to diagonally connect four lines of intersection formed by the four planes.

Since the light-emitting device 190 is thus configured such that the two wedge-shaped grooves intersect with each other to diagonally connect four lines of intersection formed by the four planes, the light-emitting device 190 can emit light that forms a rectangular illumination profile on a view plane parallel to the substrate 20. This makes it possible to provide a light-emitting device structured to be suited for a thin display device that has little illuminance unevenness or chromaticity unevenness.

In the light-emitting device 190, the sealing body may contain an LED package (wavelength conversion section) 40 that absorbs primary light emitted from the semiconductor light-emitting elements and emits secondary light.

### (Embodiment 5)

Another embodiment of the present invention is described below with reference to Fig. 20. It should be noted that the present embodiment is identical in configuration to Embodiments 1 to 4 except for that which is described in the present embodiment. Further, for convenience of explanation, members having the same functions as those shown in the drawings of Embodiments 1 to 4 are given the same reference numerals and, as such, are not described below.

Fig. 20 shows schematic diagrams showing an area active (local dimming) liquid crystal display device 500. (a) of Fig. 20 is a plan view of the area active (local dimming) liquid crystal display device 500. (b) of Fig. 20 is a transverse cross-sectional view of the area active (local dimming) liquid crystal display device 500 as taken along the line A-A'.

The area active (local dimming) liquid crystal display device 500 includes a liquid crystal display (hereinafter referred to as "display panel") 510 and, as a backlight that illuminates the back surface of the display panel 510, a planar light source 100 described in Embodiment 1.

The display panel 510 is a liquid crystal display panel that controls light transmittance for each separate pixel, and is divided into a plurality of regions including the plurality of pixels, and the planar light source 100 is also divided into a plurality of regions corresponding to those regions, with each of the regions configured to be able to be driven independently. Furthermore, the planar light source 100 is driven by a driver (not illustrated) configured to be able to adjust illuminance in accordance with an image that is displayed on the display panel 510, and is configured to be able to selectively illuminate, i.e., to strongly illuminate the back surface of a high-illuminance region of the image that is displayed on the display panel 510 and weakly illuminate the back surface of a low-illuminance region of the image that is displayed on the display panel 510. This makes it possible to reduce power consumption and improve contrast.
(c) and (d) of Fig. 20 show a positional relationship between the regions into which the display panel 510 has been divided and those into which the planar light source 100 has been divided. Let it be assumed, for example, that the display panel 510 displays an image taken of the exit 512 of a tunnel from a vehicle traveling through the tunnel, with the exit 512 seen in the vehicle's way. Then, the exit 512 of the tunnel is displayed brightly in the dark. Let it be supposed that a region of the display panel 510 where the exit 512 of the tunnel is displayed is a segment 510a and a region of the planar light source 100 which faces the back surface of the segment 510a is a segment 100a. In displaying such an image, it is only necessary to increase the luminance of the segment 100a facing the back surface of the segment 510a.

According to Embodiment 5, each of the mortar-shaped light-emitting devices 50 disposed on the mounting substrate 110 exhibits a substantially rectangular illumination profile and illuminates a limited region having a substantially square shape. Therefore, only a negligible amount of light diffuses into regions other than the region. This makes it possible to reduce crosstalk where light leaks into an adjacent segment. Therefore, a planar light source mounted with mortar-shaped light-emitting devices 50 can be suitably used as a backlight of an area active (local dimming) display device.

It should be noted that the planar light source is not limited to that described in Embodiment 1, and may be that described in Embodiment 2, 3, or 4. Further, the display device is not limited to a liquid crystal display device, and only needs to be a general display device that varies in light transmittance from region to region.

A planar light source of the present invention includes: a mounting substrate; and a plurality of light-emitting devices as described in any one of the embodiments, the plurality of light-emitting devices being arrayed on the mounting substrate to serve as the planar light source, the light-emitting devices being arrayed in such a way as to form respective rectangular illumination profiles having sides parallel to one another. This makes it possible to provide a planar light source structured to be suitable for a thin display device that has little illuminance unevenness or chromaticity unevenness.

A display device of the present invention includes: a planar light source described above; and a display panel that varies in light transmission from region to region, the planar light source illuminating the back surface of the display panel. This makes it possible to provide a thin display device that has little illuminance unevenness or chromaticity unevenness.

The present invention is not limited to the description of the embodiments above. For example, it is self-evident that although the sealing resin has been described as having a substantially square shape as viewed planimetrically, the sealing resin cannot be prevented from having a substantially oblong shape as viewed planimetrically. That is, the present invention may be altered within the scope of the claims. An embodiment based on a proper combination of technical means disclosed in different embodiments is encompassed in the technical scope of the present invention.

In the embodiments above, area active (local dimming) driving results in great interference between one region and another. Therefore, it is OK to replace a light-emitting device of any of the embodiments above with a light-emitting device having an illumination profile, based on a rectangular illumination profile in the form of a square or an oblong shape, which has its vertices slightly protruding diagonally, although it is not desirable that the vertices too greatly protrude diagonally as in the illumination profile of a comparative example of a cloverleaf light-emitting device 70.

### (Additional Embodiment 1)

The present embodiment is a modification of Embodiment 1 of (a) through (d) of Fig. 2 and (a) through (d) of Fig. 4.

This modification differs from Embodiment 1 in that the substrate 20 has an oblong shape, that the opening in the mortar-shaped slope 10b (i.e., the junction between the ceiling surface 10a and the slope 10b), when viewed planimetrically, has an oval or elliptic shape that extends along the longer sides of the substrate 20, and that the wavelength conversion section 40, when viewed planimetrically, has its edge in an oval shape that falls within the opening.

Fig. 22 shows a top view and a side view of an example where the opening has an elliptic shape in a light-emitting device according to this modification.

### (Additional Embodiment 2)

Fig. 23 shows a top view and a side view of the present light-emitting device.

The present embodiment is a modification of Embodiment 2 of (a) through (d) of Fig. 13.

As with Additional Embodiment 1, the present embodiment is a case example where the substrate 20 has an oblong shape, where the opening in the wedge-shaped slope (i.e., the junction between the ceiling surface 10a and the slope 10b), when viewed planimetrically, has an elliptic shape that extends along the longer sides of the substrate 20, and where the wavelength conversion section 40, when viewed planimetrically, has its edge in an oval shape that falls within the opening. The wedge-shaped slope has both of its ends in a surface shape of a halved inverted cone.

In the embodiments above, light-emitting devices each having a rectangular illumination profile in the form of a square or an oblong shape on a view plane parallel to the substrate and a planar light source constituted by such light-emitting devices have been described. It should be noted, however, that the rectangular illumination profile needs only be such a shape that a surface is filled with light-emitting patterns with no space therebetween, and may for example be triangular, hexangular, or octangular.

### [General Overview of Embodiments]

The planar light source 100 and 200 may each be configured such that the first intervals and the second intervals are equal.

The planar light source 100 and 200 may each be configured such that the first intervals are shorter than the second intervals.

The planar light source 100 and 200 may each be configured such that the direction in which the light sources each emit light of maximum intensity and the vertical direction form an angle of 30 degrees or larger to 50 degrees or smaller.

The planar light source 100 and 200 may each be configured such that on a virtual viewing plane parallel to the mounting substrate 110, the light sources each has a contour of an illumination profile in a rectangular shape with rounded vertices.

The planar light source 100 and 200 may each be configured such that the illumination profile has one side parallel or substantially parallel to the first direction.

The planar light source 100 and 200 may each be configured such that the first intervals are each 15 mm or longer and a value obtained by dividing each of the distance by each of the first intervals is smaller than 0.7.

The planar light source 100 may be configured such that each of the light sources is a light source including: a substrate 20; an LED chip 25 die-bonded to the substrate 20; and a lens covering the LED chip 25, the lens including (i) four surfaces 13a to 13d standing upright with respect to the substrate 20 and (ii) a top surface 10a right opposite the substrate 20, the top surface 10a having a concavely sunken part formed therein.

The planar light source 200 may be configured such that each of the light sources is a light source including: a substrate 20; an long LED chip 65 die-bonded to the substrate 20; and a lens covering the long LED chip 65, the lens including (i) four surfaces 13a to 13d standing upright with respect to the substrate 20 and (ii) a top surface 10a right opposite the substrate 20, the top surface 10a having a concavely sunken part formed therein.

The planar light source 100 may be configured such that the lens serves as a sealing body that seals in the LED chip 25.

The planar light source 200 may be configured such that the lens serves as a sealing body that seals in the long LED chip 65.

The planar light source 100 and 200 may each be configured such that the sunken part has a circular conical shape, a truncated circular conical shape, a polygonal conical shape, or a truncated polygonal conical shape having its vertex pointing to the substrate 20.

The planar light source 100 may be configured such that the LED chip 25 is placed in an area around a central axis of the sunken part.

The planar light source 200 may be configured such that the long LED chip 65 is placed in an area around a central axis of the sunken part.

The planar light source 100 may further include a wavelength conversion section 40, sandwiched between the LED chip 25 and the lens, which covers the LED chip 25, the wavelength conversion section 40 being composed of a resin layer containing a fluorescent substance dispersed in advance therein, the fluorescent substance absorbing primary light emitted from the LED chip 25 and emitting secondary light.

The planar light source 200 may further include a wavelength conversion section 40, sandwiched between the long LED chip 65 and the lens, which covers the long LED chip 65, the wavelength conversion section 40 being composed of a resin layer containing a fluorescent substance dispersed in advance therein, the fluorescent substance absorbing primary light emitted from the long LED chip 65 and emitting secondary light.

A display device according to the present embodiment includes a planar light source 100 and a liquid crystal panel 150 that varies in light transmission from one pixel to another, and the planar light source 100 illuminates the back surface of the liquid crystal panel 150. This makes it possible to provide a thin display device that has little illuminance unevenness or chromaticity unevenness.

A display device according to the present embodiment includes a planar light source 200 and a liquid crystal panel 150 that varies in light transmission from one pixel to another, and the planar light source 200 illuminates the back surface of the liquid crystal panel 150. This makes it possible to provide a thin display device that has little illuminance unevenness or chromaticity unevenness.

The foregoing display devices are both configured such that: the liquid crystal panel 150 is configured to be able to be driven for each separate region including the plurality of pixels; and the planar light source 100 or 200 is configured such that its luminance is able to be adjusted for each separate region including the plurality of pixels.

### Industrial Applicability

The present invention is used as a light source for use in a backlight that illuminates the back surface of a liquid crystal display panel. Further, the present invention is used as a light source for use in a backlight suitable for an area active (local dimming) liquid crystal display device. Furthermore, the present invention can be applied to a lighting apparatus.

### Reference Signs List

- 10, 71: Sealing lens (lens, sealing body)
- 10a: Top surface (ceiling surface)
- 10b: Slope
- 10c: Vertex
- 11: Main axis
- 11a: Center
- 12: Point of intersection
- 12a, 12b: Space area
- 12c: Central space area
- 13a, 13b, 13c, 13d: Side surface
- 20: Substrate
- 24: Imaginary square
- 25: LED chip (semiconductor light-emitting element)
- 40: Wavelength conversion section
- 52: Bright portion
- 56: Outer edge surface
- 60: Domed light-emitting device
- 61: Sealing body (sealing body)
- 65: Long LED chip (semiconductor light-emitting element)
- 70: Cloverleaf light-emitting device
- 72: Bright portion
- 74: Dark portion
- 58, 78: Contour line
- 80: Wedge-shaped light-emitting device
- 80a: Raised part
- 80b: Depressed part
- 81a: Center
- 90, 190: Light-emitting device
- 100, 200: Planar light source (planar light source device)
- 100a, 510a: Segment
- 110: Mounting substrate
- 112: Diffusion plate
- 113: Group of optical sheets put on top of one another
- 113a: First unevenness eliminating sheet (optical sheet)
- 113b: Second unevenness eliminating sheet (optical sheet)
- 113c, 113d: Luminance improving sheet
- 114: Array axis
- 201: Dark area
- 202: Bright area
- 50: Mortar-shaped light-emitting device (light source)
- 121 to 123: Mortar-shaped light-emitting device
- 150: Liquid crystal panel (display panel)
- 500: Liquid crystal display device
- 510: Liquid crystal display panel
- 512: Exit
- d: Distance (interval)
- B: Diagonal direction
- C: Diagonal direction
- D: Longitudinal direction (busbar direction)
- E: Direction
- P, Px: Pitch (first interval)
- Py: Pitch (second interval)
- P': Pitch (third interval)
- θ: Angle of inclination
- θc, βc: Critical angle

## Claims

1. A planar light source device comprising:
a plurality of light sources arrayed at first intervals along a first direction on a mounting substrate and arrayed at second intervals along a second direction orthogonal to the first direction; and
a plurality of optical sheets placed in parallel with the mounting substrate at a distance from the mounting substrate,
the light sources each emitting light of maximum intensity in a direction inclined at an oblique angle with respect to a direction vertical to a plane on which the light sources are placed,
on a plane containing the vertical direction and the direction along which the light sources are arrayed, the direction in which the light sources each emit light of maximum intensity forming an angle α1 with the vertical direction,
on a plane containing the vertical direction and a diagonal direction across the array of light sources, the direction in which the light sources each emit light of maximum intensity forming an angle α2 with the diagonal direction,
α1 being less than α2,
the optical sheets each having surfaces one of which is more distant from the light sources than the other and is shaped such that shapes having upwardly convex cross-sections and extending along a longitudinal direction are arranged at third intervals,
the first intervals and the second intervals being longer than the third intervals.

2. The planar light source device as set forth in claim 1, wherein the first intervals and the second intervals are equal.

3. The planar light source device as set forth in claim 1, wherein the first intervals are shorter than the second intervals.

4. The planar light source device as set forth in any one of claims 1 to 3, wherein the direction in which the light sources each emit light of maximum intensity and the vertical direction form an angle of 30 degrees or larger to 50 degrees or smaller.

5. The planar light source device as set forth in any one of claims 1 to 3, wherein on a virtual view plane parallel to the mounting substrate, the light sources each has a contour of an illumination profile in a rectangular shape with rounded vertices.

6. The planar light source device as set forth in claim 5, wherein the illumination profile has one side parallel to the first direction.

7. The planar light source device as set forth in any one of claims 1 to 6, wherein the first intervals are each 15 mm or longer and a value obtained by dividing each of the distance by each of the first intervals is smaller than 0.7.

8. The planar light source device as set forth in any one of claims 4 to 7, wherein each of the light sources is a light source including:
a substrate;
a semiconductor light-emitting element die-bonded to the substrate; and
a lens covering the semiconductor light-emitting element,
the lens including (i) four surfaces standing upright with respect to the substrate and (ii) a ceiling surface right opposite the substrate,
the ceiling surface having a concavely sunken part formed therein.

9. The planar light source device as set forth in claim 8, wherein the lens serves as a sealing body that seals in the semiconductor light-emitting element.

10. The planar light source device as set forth in claim 8 or 9, wherein the sunken part has a circular conical shape, a truncated circular conical shape, a polygonal conical shape, or a truncated polygonal conical shape having its vertex pointing to the substrate.

11. The planar light source device as set forth in claim 10, wherein the semiconductor light-emitting element is placed in an area around a central axis of the sunken part.

12. The planar light source device as set forth in any one of claims 8 to 11, further comprising a wavelength conversion section, sandwiched between the semiconductor light-emitting element and the lens, which covers the semiconductor light-emitting element, the wavelength conversion section being composed of a resin layer containing a fluorescent substance dispersed in advance therein, the fluorescent substance absorbing primary light emitted from the semiconductor light-emitting element and emitting secondary light.

13. A display device comprising:
a planar light source device as set forth in any one of claims 1 to 12; and
a display panel that varies in light transmission from one pixel to another,
the planar light source device illuminating a back surface of the display panel.

14. A display device as set forth in claim 13, wherein:
the display panel is configured to be able to be driven for each separate region including the plurality of pixels; and
the planar light source device is configured such that its luminance is able to be adjusted for each separate region including the plurality of pixels.
